# EUROPÄISCHE PATENTSCHRIFT

(11) **EP 1 787 284 B1**
(45) Veröffentlichungstag und Bekanntmachung des Hinweises auf die Patenterteilung: **19.12.2007**
(21) Anmeldenummer: 05772450.2
(22) Anmeldetag: 21.07.2005
(51) Int. Cl.: G10L 11/00, G06F 17/30

(54) **VORRICHTUNG UND VERFAHREN ZUR ROBUSTEN KLASSIFIZIERUNG VON AUDIOSIGNALEN SOWIE VERFAHREN ZU EINRICHTUNG UND BETRIEB EINER AUDIOSIGNAL-DATENBANK SOWIE COMPUTER-PROGRAMM**
DEVICE AND METHOD FOR ROBUSTLY CLASSIFYING AUDIO SIGNALS, METHOD FOR ESTABLISHING AND OPERATING AUDIO SIGNAL DATABASE AND A COMPUTER PROGRAM
PROCEDE ET APPAREIL DE CLASSIFICATION FIABLE DE SIGNAUX SONORES, PROCEDE POUR INSTALLER ET FAIRE FONCTIONNER UNE BANQUE DE DONNEES DE SIGNAUX SONORES, ET PROGRAMME INFORMATIQUE

(30) Priorität: 26.07.2004 DE 102004036154
(43) Veröffentlichungstag der Anmeldung: 23.05.2007
(73) Patentinhaber: m2any GmbH, 85748 Garching (DE)
(72) Erfinder: ALLAMANCHE, Eric, Emeryville, California 94608 (US); HERRE, Jürgen, 91054 Buckenhof (DE); HELLMUTH, Oliver, 91052 Erlangen (DE); KASTNER, Thorsten, 96342 Stockheim/Reitsch (DE); CREMER, Markus, Berkeley, California 94707 (US)
(74) Vertreter: Schoppe, Fritz
(86) Internationale Anmeldenummer: PCT/EP2005/007971
(87) Internationale Veröffentlichungsnummer: WO 2006/010561

(56) Entgegenhaltungen:
- JIN SOO SEO, JAAP HAITSMA, AND TON KALKER: "Linear speed-change resilient audio fingerprinting" PROC. 1ST IEEE BENELUX WORKSHOP ON MODEL BASED PROCESSING AND CODING OF AUDIO (MPCA-2002), 15. November 2002 (2002-11-15), Seiten 45-48, XP002356763 Leuven, Belgium in der Anmeldung erwähnt & JAAP HAITSMA ET AL: "A highly robust audio fingerprinting system" JOURNAL OF NEW MUSIC RESEARCH, Bd. 32, Nr. 2, 17. Oktober 2002 (2002-10-17), Seiten 211-221, XP002278848 Netherlands
- WANG Y ET AL: "MULTIMEDIA CONTENT ANALYSIS USING BOTH AUDIO AND VISUAL CLUES" IEEE SIGNAL PROCESSING MAGAZINE, IEEE SERVICE CENTER, PISCATAWAY, NJ, US, November 2000 (2000-11), Seiten 12-36, XP001127426 ISSN: 1053-5888
- LANCINI R ET AL: "Audio content identification by using perceptual hashing" MULTIMEDIA AND EXPO, 2004. ICME '04. 2004 IEEE INTERNATIONAL CONFERENCE ON TAIPEI, TAIWAN JUNE 27-30, 2004, PISCATAWAY, NJ, USA,IEEE, Bd. 1, 27. Juni 2004 (2004-06-27), Seiten 739-742, XP010770917 ISBN: 0-7803-8603-5
- KIMURA A ET AL: "Very quick audio searching: introducing global pruning to the Time-Series Active Search" 2001 IEEE INTERNATIONAL CONFERENCE ON ACOUSTICS, SPEECH, AND SIGNAL PROCESSING. PROCEEDINGS. (ICASSP). SALT LAKE CITY, UT, MAY 7 - 11, 2001, IEEE INTERNATIONAL CONFERENCE ON ACOUSTICS, SPEECH, AND SIGNAL PROCESSING (ICASSP), NEW YORK, NY : IEEE, US, Bd. VOL. 1 OF 6, 7. Mai 2001 (2001-05-07), Seiten 1429-1432, XP010803156 ISBN: 0-7803-7041-4
- CANO P ET AL: "A review of algorithms for audio fingerprinting" PROCEEDINGS OF THE 2003 IEEE RADAR CONFERENCE. HUNTSVILLE, AL, MAY 5 - 8, 2003, IEEE RADAR CONFERENCE, NEW YORK, NY : IEEE, US, 9. Dezember 2002 (2002-12-09), Seiten 169-173, XP010642539 ISBN: 0-7803-7920-9
- PAPODYSSEUS C ET AL: "A NEW APPROACH TO THE AUTOMATIC RECOGNITION OF MUSICAL RECORDINGS" JOURNAL OF THE AUDIO ENGINEERING SOCIETY, AUDIO ENGINEERING SOCIETY, NEW YORK, NY, US, Bd. 49, Nr. 1/2, Januar 2001 (2001-01), Seiten 23-35, XP001112482 ISSN: 1549-4950
- SEO J S ET AL: "Audio Fingerprinting Based on Normalized Spectral Subband Centroids" ACOUSTICS, SPEECH, AND SIGNAL PROCESSING, 2005. PROCEEDINGS. (ICASSP '05). IEEE INTERNATIONAL CONFERENCE ON PHILADELPHIA, PENNSYLVANIA, USA MARCH 18-23, 2005, PISCATAWAY, NJ, USA,IEEE, 18. März 2005 (2005-03-18), Seiten 213-216, XP010792367 ISBN: 0-7803-8874-7

## Beschreibung

Die vorliegende Erfindung bezieht sich im allgemeinen auf eine Vorrichtung und ein Verfahren zur robusten Klassifizierung von Audiosignalen sowie auf ein Verfahren zur Einrichtung und zum Betrieb einer Audiosignal-Datenbank, im speziellen auf eine Vorrichtung und ein Verfahren zur Klassifizierung von Audiosignalen, bei dem ein Fingerabdruck für das Audiosignal generiert und ausgewertet wird.

In den letzten Jahren ist die Verfügbarkeit multimedialen Datenmaterials immer mehr gestiegen. Leistungsfähige Computer, die stark zunehmende Verfügbarkeit von breitbandigen Datennetzen, leistungsfähige Kompressionsverfahren und Speichermedien mit einer hohen Kapazität haben dazu wesentlich beigetragen. Besonders stark ist der Anstieg der Anzahl an verfügbaren Audioinhalten. Besonders große Verbreitung finden hierbei Audiodateien, die gemäß dem MPEG1/2-Layer 3 Standard, kurz als MP3 bezeichnet, codiert sind.

Die große Menge an Audiodaten, die sehr oft Musikstücke repräsentieren, macht es erforderlich, Vorrichtungen und Verfahren zu entwickeln, die ein Klassifizieren von Audiodaten und ein Auffinden von bestimmten Audiodaten ermöglichen. Da die Audiodaten in verschiedenen Formaten vorliegen, die beispielsweise durch verlustbehaftete Komprimierung oder durch Übertragung über einen verzerrungsbehafteten Übertragungskanal nicht in jedem Fall eine exakte Rekonstruktion des Audioinhalts ermöglichen, sind Verfahren nötig, die Audiosignale nicht aufgrund der wertemäßigen Repräsentation beurteilen bzw. vergleichen, sondern aufgrund einer inhaltsbasierten Charakterisierung.

Ein Einsatzgebiet für eine Einrichtung zur inhaltsbasierten Charakterisierung eines Audiosignals ist beispielsweise das Bereitstellen von Metadaten zu einem Audiosignal. Dies ist insbesondere in Verbindung mit Musikstücken relevant. Hierbei kann zu einem gegebenen Ausschnitt eines Musikstücks der Titel und der Interpret bestimmt werden. Auch zusätzliche Informationen, beispielsweise über das Album, auf dem der Musiktitel enthalten ist, sowie urheberrechtliche Informationen können so ermittelt werden.

Merkmale eines Audiosignals müssen bei einer inhaltsbasierten Charakterisierung aus der vorliegenden Repräsentation eines Audiosignals extrahiert werden. Insbesondere hat es sich als günstig erwiesen, einem Audiosignal einen Satz von Daten zuzuordnen, der aufgrund des Audioinhalts des Audiosignals gewonnen wird, und der zum Klassifizieren, Suchen oder Vergleichen eines Audiosignals vorteilhaft verwendet werden kann. Ein solcher Satz von Daten wird auch als Fingerabdruck bezeichnet.

In den letzten Jahren wurde eine Reihe von Verfahren zur inhaltsbasierten Indizierung von Audiosignalen veröffentlicht. Mit solchen Vorrichtungen können Musiksignale, oder allgemein akustische Signale, anhand einer vorgegebenen Eigenschaft einer bestimmten Klasse oder Muster zugeordnet werden. Somit lassen sich akustische Signale nach bestimmten Ähnlichkeiten einordnen.

Im folgenden werden die wesentlichen Anforderungen an einen Fingerabdruck eines Audiosignals näher beschrieben. Aufgrund der großen Anzahl an verfügbaren Audiosignalen ist es erforderlich, dass der Fingerabdruck mit einem moderaten Rechenaufwand erzeugt werden kann. Dies verringert die zur Erzeugung des Fingerabdrucks benötigte Zeit und macht einen Einsatz des Fingerabdrucks im großen Maßstab erst möglich. Weiterhin darf der Fingerabdruck nicht zu viel Speicher einnehmen. In vielen Fällen ist es erforderlich, eine große Anzahl von Fingerabdrücken in einer Datenbank zu speichern.

Insbesondere kann es erforderlich sein, eine große Anzahl an Fingerabdrücken im Hauptspeicher eines Rechners zu halten. Daraus ist es klar ersichtlich, dass die Datenmenge des Fingerabdrucks deutlich kleiner sein muss als die Datenmenge des eigentlichen Audiosignals. Andererseits ist es erforderlich, dass der Fingerabdruck für ein Audiostück charakteristisch ist. Das heißt, zwei Audiosignale mit unterschiedlichem Inhalt müssen auch einen unterschiedlichen Fingerabdruck haben. Weiterhin ist es eine wichtige Anforderung an einen Fingerabdruck, dass die Fingerabdrücke zweier Audiosignale, die den gleichen Audioinhalt repräsentieren, sich aber beispielsweise durch eine Verzerrung voneinander unterscheiden, hinreichend ähnlich sind, um bei einem Vergleich als zusammengehörig identifiziert zu werden. Diese Eigenschaft wird typischerweise als Robustheit des Fingerabdrucks bezeichnet. Sie ist besonders wichtig, wenn Audiosignale verglichen werden sollen, die mit verschiedenen Verfahren komprimiert bzw. codiert worden sind. Weiterhin sollen Audiosignale, die über einen verzerrungsbehafteten Kanal übertragen worden sind, einen dem ursprünglichen Fingerabdruck sehr ähnlichen Fingerabdruck aufweisen.

Es sind bereits eine Reihe von Verfahren bekannt, mit deren Hilfe Merkmale bzw. Fingerabdrücke aus einem Audiosignal extrahiert werden können. Das US-Patent Nr. 5,918,223 offenbart ein Verfahren für die inhaltsbasierte Analyse, Speicherung, Wiedergewinnung und Segmentierung von Audioinformationen. Eine Analyse von Audiodaten erzeugt einen Satz von numerischen Werten, der auch als Merkmalsvektor bezeichnet wird, und der dazu verwendet werden kann, um die Ähnlichkeit zwischen einzelnen Audiostücken zu klassifizieren und rangmäßig zu ordnen. Als Merkmale zur Charakterisierung bzw. Klassifizierung von Audiostücken hinsichtlich ihres Inhalts wird die Lautheit eines Stücks, die Tonhöhe, die Tonhelligkeit, die Bandbreite und die sogenannten Mel-Frequenz-Cepstral-Koeffizienten (MFCCs) eines Audiostücks verwendet. Die Werte pro Block oder Frame werden gespeichert und einer ersten Ableitung nach der Zeit unterzogen. Hieraus werden statistische Größen berechnet, wie z.B. der Mittelwert oder die Standardabweichung, und zwar von jedem dieser Merkmale einschließlich der ersten Ableitungen derselben, um eine Variation über der Zeit zu beschreiben. Dieser Satz von statistischen Größen bildet den Merkmals-Vektor. Der Merkmals-Vektor ist somit ein Fingerabdruck des Audiostücks und kann in einer Datenbank gespeichert werden.

Die Fachveröffentlichung "Multimedia Content Analysis", Yao Wang u.a., IEEE Signal Processing Magazine, November 2000, Seiten 12 bis 36, offenbart ein ähnliches Konzept, um Multimediastücke zu indizieren und charakterisieren. Um eine effiziente Zuordnung eines Audiosignals zu einer bestimmten Klasse zu gewährleisten, wurden eine Reihe von Merkmalen und Klassifikatoren entwickelt. Als Merkmal zum Klassifizieren des Inhalts eines Multimediastücks werden Zeitbereichsmerkmale oder Frequenzbereichsmerkmale vorgeschlagen. Diese umfassen die Lautstärke, die Tonhöhe als Grundfrequenz einer Audiosignalform, spektrale Merkmale, wie z.B. den Energieinhalt eines Bandes bezogen auf den Gesamtenergieinhalt, Grenzfrequenzen im Spektralverlauf und andere. Neben Kurzzeitmerkmalen, die die sogenannten Größen pro Block von Abtastwerten des Audiosignals betreffen, werden auch Langzeitgrößen vorgeschlagen, die sich auf einen längeren Zeitraum des Audiostücks beziehen. Weitere typische Merkmale werden durch die zeitliche Differenzbildung der jeweiligen Merkmale gebildet. Die blockweise gewonnenen Merkmale werden selten direkt als solche zur Klassifikation weitergegeben, da sie noch eine viel zu hohe Datenrate aufweisen. Eine gängige Form der weiteren Verarbeitung besteht in der Berechnung von Kurzzeitstatistiken. Dazu gehören z.B. die Bildung von Mittelwert, Varianz und zeitlichen Korrelationskoeffizienten. Dies reduziert die Datenrate und resultiert andererseits in einer besseren Wiedererkennung eines Audiosignals.

In der WO 02/065782 wird ein Verfahren zum Bilden eines Fingerabdrucks zu einem Multimediasignal beschrieben. Das Verfahren beruht auf der Extraktion von einem oder mehreren Merkmalen aus einem Audiosignal. Das Audiosignal wird hierzu in Segmente aufgeteilt und in jedem Segment erfolgt eine Verarbeitung nach Blöcken und Frequenzbändern. Als Beispiele werden die bandweise Berechnung der Energie, Tonalität und Standardabweichung des Leistungsdichtespektrums genannt.

Weiterhin ist aus DE 101 34 471 und DE 101 09 648 eine Vorrichtung und ein Verfahren zum Klassifizieren eines Audiosignals bekannt, bei denen der Fingerabdruck aufgrund eines Maßes für die Tonalität des Audiosignals gewonnen wird. Der Fingerabdruck ermöglicht dabei eine robuste, inhaltsbasierte Klassifizierung von Audiosignalen. Die genannten Schriften zeigen dabei mehrere Möglichkeiten auf, um ein Tonalitätsmaß über ein Audiosignal zu erzeugen. In jedem Fall liegt der Berechnung der Tonalität eine Umsetzung eines Segments des Audiosignals in den Spektralbereich zugrunde. Die Tonalität kann dann für ein Frequenzband oder für alle Frequenzbänder parallel berechnet werden. Der Nachteil eines solchen Verfahrens ist, dass der Fingerabdruck bei zunehmender Verzerrung der Audiosignale nicht mehr aussagekräftig genug ist, und dass eine Erkennung des Audiosignals dann nicht mehr mit zufriedenstellender Zuverlässigkeit möglich ist. Verzerrungen jedoch treten in sehr vielen Fällen auf, insbesondere wenn Audiosignale über ein System mit geringer Übertragungsqualität übertragen werden. Dies ist gegenwärtig insbesondere bei mobilen Systemen bzw. im Falle starker Datenkompression der Fall. Solche Systeme, wie z.B. Mobiltelefone, sind primär zur bidirektionalen Übertragung von Sprachsignalen ausgelegt und übertragen Musiksignale häufig nur mit einer sehr geringen Qualität. Dazu kommen weitere Faktoren, die einen negativen Einfluß auf die Qualität eines übertragenen Signals haben können, z.B. Mikrofone geringer Qualität, Kanalstörungen und Transcodierungseffekte. Die Folge einer Verschlechterung der Signalqualität ist in Bezug auf eine Vorrichtung zur Identifizierung und Klassifizierung eines Signals eine stark verschlechterte Erkennungsleistung. Untersuchungen haben ergeben, daß insbesondere bei Verwendung einer Vorrichtung bzw. eines Verfahrens gemäß DE 101 34 471 und DE 101 09 648 Änderungen an dem System unter Beibehaltung des Erkennungskriteriums Tonalität (Spectral Flatness Measure) keine weiteren signifikanten Verbesserungen der Erkennungsleistung möglich sind.

Es kann festgehalten werden, dass bekannte Verfahren zur Klassifizierung von Audiosignalen bzw. zur Bildung eines Fingerabdrucks eines Audiosignals zumeist nicht die gestellten Anforderungen erfüllen können. Probleme bestehen nach wie vor hinsichtlich der Robustheit gegenüber Verzerrungen des Audiosignals, auch gegenüber Störungen, die dem Audiosignal überlagert sind.

Bei einer Vielzahl von gegenwärtigen Systemen zur Speicherung und Übertragung von Audiosignalen treten starke Signalverzerrungen und Störungen auf. Dies ist insbesondere dann der Fall, wenn ein verlustbehaftetes Datenkomprimierungsverfahren oder ein gestörter Übertragungskanal verwendet wird. Verlustbehaftete Komprimierung wird immer dann eingesetzt, wenn die zur Speicherung oder Übertragung eines Audiosignals nötige Datenrate reduziert werden soll. Beispiele sind die Datenkompression gemäß dem MP3-Standard und die bei digitalen Mobilfunkgeräten eingesetzten Verfahren. In beiden Fällen werden niedrige Datenraten dadurch erzielt, dass für die Übertragung eine möglichst grobe Quantisierung der Signale erfolgt. Die Audio-Bandbreite ist teilweise stark eingeschränkt. Zusätzlich werden Signalanteile unterdrückt, die vom menschlichen Gehör nicht oder nur sehr schwach wahrgenommen werden, weil sie beispielsweise von anderen Signalanteilen maskiert werden.

Störungen auf dem Übertragungskanal treten bei heute üblichen mobilen Sprachübertragungsanwendungen sehr häufig auf.

Insbesondere ist die Empfangsqualität nicht selten gering, was sich durch ein erhöhtes Rauschen auf dem übertragenen Audiosignal bemerkbar macht. Daneben kann die Übertragung für kurze Zeit vollkommen unterbrochen sein, so dass ein kurzes Teilstück eines zu übertragenden Audiosignals vollständig fehlt. Ein Mobiltelefon erzeugt während einer solchen Unterbrechung ein Rauschsignal, das von einem menschlichen Benutzer als weniger stark störend empfunden wird als eine vollständige Austastung des Audiosignals. Schließlich treten auch bei der Übergabe von einer Mobilfunkzelle zu einer anderen Störungen auf. All diese Störeinflüsse dürfen einen Fingerabdruck nicht zu stark verfälschen, so dass eine Identifizierung eines gestörten Audiosignals immer noch mit hoher Sicherheit möglich ist.

Schließlich wird die Übertragung von Audiosignalen auch durch die Frequenzgangcharakteristik des Audioteils beeinträchtigt. Insbesondere kleine und billige Komponenten, wie sie häufig bei mobilen Geräten eingesetzt werden, weisen einen ausgeprägten Frequenzgang auf und verzerren somit die zu identifizierenden Audiosignale.

Während ein menschlicher Hörer ein Audiosignal auch bei Vorliegen der beschriebenen Störungen und Verzerrungen noch mit hoher Zuverlässigkeit identifizieren kann, verringert sich bei Audiosignal-Erkennungseinrichtungen, die einen herkömmlichen Fingerabdruck eines Audiosignals verwenden, die Erkennungsleistung bei Vorliegen von gestörten Audiosignalen merklich.

Die Veröffentlichung "Linear Speed-Change Resilient Audio Fingerprinting" von J. S. Seo et al., veröffentlicht in den Proceedings 1st IEEE Benelux Workshop on Model based Processing and Coding of Audio (MPCA-2002), Leuven, Belgium, November 15, 2002, beschreibt ein Verfahren für Geschwindigkeits-unempfindliche Audio-Fingerabdrücke, das auf Invarianz-Eigenschaften der Fourier-Mellin-Transformation basiert. Ein Audiosignal wird dabei in Rahmen aufgeteilt, und eine spektrale Repräsentation wird durch Ausführung einer Fourier-Transformation erhalten. Von dem resultierenden Spektrum wird ein Vektor bestehend aus 33 Energien berechnet, indem die Energie in 33 logarithmisch beabstandeten Bändern berechnet wird. Die Bänder liegen in dem Bereich zwischen 300 Hz und 2000 Hz. Die Energievektoren von aufeinanderfolgenden Rahmen werden dann in Zeilen einer Matrix gesetzt, um ein Spektrogramm zu erhalten. Das Spektrogramm wird mit einem einfachen 2D-Filter entlang der Frequenzachse und entlang der Zeitachse unter Verwendung eines Filterkernel F_{ω,t} gefiltert. Abschließend werden die gefilterten Energiewerte in Bits konvertiert, indem das Vorzeichen des entstehenden Wertes verwendet wird.

Weitere Einzelheiten diesbezüglich finden sich auch in der Veröffentlichung "A Highly Robust Audio Fingerprinting System" von J. Haitsma et al., veröffentlicht im Journal of New Music Research, Band 32, Nr. 2, 17. Oktober 2002, Seiten 211-221.

Der Artikel "Audio Content Identification by using Perceptual Hashing" von R. Lancini et al., veröffentlicht auf der IEEE International Conference on Multimedia and Expo, Taipeh, Taiwan, 27. bis 30. Juni 2004, Band 1, Seiten 739-742, beschreibt ein Hash-Verfahren zur automatischen Liederkennung. Das Verfahren umfasst eine Vorverarbeitung eines Audiosignals, eine Einteilung in Rahmen, ein Fenstern, eine FFT-Transformation sowie eine Merkmalsextraktion. Als Merkmale werden eine mittlere Energie, ein spektrales Flachheitsmaß sowie ein spektraler Crest-Faktor verwendet. An schließend findet eine Modellierung des Fingerabdrucks statt.

Die Veröffentlichung "Very Quick Audio Searching: Introducing Global Pruning To The Time-Series Active Search" von A. Kimura et al., veröffentlicht in den Proceedings der IEEE International Conference on Acoustics, Speech and Signal Processing, 2001, Vol. 1 of 6, 7. Mai 2001, Seiten 1429-1432, beschreibt ein Vorverarbeitungs-Verfahren, das ein Suchverfahren zum Durchsuchen von Audio- oder Videoaufnahmen nach einem spezifizierten Segment beschleunigt. Das Verfahren umfasst ein globales Histogramm-Gruppieren von langen Signalen und ein Verfahren zum Entfernen überflüssiger Informationen unter Verwendung der Gruppen bzw. Cluster. Bei dem Verfahren wird ein Merkmalsvektor bestimmt, dessen Elemente normierte Kurzzeitleistungsspektren darstellen. Die Merkmalsvektoren werden dann unter Verwendung eines Vektorquantisierungsalgorithmus quantisiert, woraufhin unter Verwendung der quantisierten Vektoren Histogramme erstellt werden.

Der Artikel "A Review of Algorithms for Audio Fingerprinting" von P. Cano et al., veröffentlicht in den Proceedings of the 2003 IEEE Radar Conference, auf den Seiten 169-173, liefert Hintergrundinförmationen zu verschiedenen Audio-Fingerabdrücken.

Der Artikel "A New Approach to the Automatic Recognition of Musical Recordings" von C. Papaodysseus et al., veröffentlicht in dem Journal of the Audio Engineering Society, Band 49, Nr. 1/2, Januar 2001, auf den Seiten 23-35, liefert weitere Hindergrundinformationen im Hinblick auf eine Methode zur automatischen Erkennung von Musikaufzeichnungen und zur Erstellung eines Satzes von repräsentativen Vektoren für eine unbekannte Musikaufnahme. Der genannte Artikel geht ferner auf die Berechnung einer adaptiven FFT-Transformation ein und widmet sich ferner der Codierung der Charakteristik einer Musikaufnahme. Ferner beschreibt der Artikel Algorithmen zur Erkennung einer Übereinstimmung von Mustern.

Der nachveröffentlichte Artikel "Audio Fingerprinting Based On Normalized Spectral Subband Centroids" von J. S. Seo et al., veröffentlicht in den Proceedings of the IEEE International Conference on Acoustics, Speech and Signal Processing, 18. März 2005, auf den Seiten 213-216, beschreibt ferner ein weiteres Verfahren zur Erstellung eines Audio-Fingerabdrucks unter Verwendung normierter spektraler Subband-Schwerpunkte.

Aufgabe der vorliegenden Erfindung ist es, ein Konzept zur Berechnung eines robusteren Fingerabdrucks aufgrund eines Audiosignals zu schaffen.

Diese Aufgabe wird durch eine Vorrichtung und ein Verfahren zum Erzeugen eines Fingerabdrucksignals aus einem Audiosignal gemäß den Ansprüchen 1 bzw. 25, durch eine Vorrichtung und ein Verfahren zum Charakterisieren eines Audiosignals gemäß den Ansprüchen 26 bzw. 27 sowie durch ein Verfahren zur Einrichtung einer Audiodatenbank gemäß Anspruch 28, ein Verfahren zum Gewinnen von Informationen aufgrund einer Audiosignal-Datenbank gemäß Anspruch 29 und ein Computerprogramm gemäß Anspruch 31 gelöst.

Die vorliegende Erfindung beruht auf der Erkenntnis, dass ein Fingerabdrucksignal zu einem Audiosignal dann robust gegen Störungen ist, wenn ein Merkmal des Signals verwendet wird, das von verschiedenen Verzerrungen des Signals weitgehend unbeeinflusst ist und das in einer ähnlichen Form der akustischen Wahrnehmung des Menschen zugänglich ist, das also Bandenergien und insbesondere skalierte Bandenergien umfaßt, wobei durch Filtern des zeitlichen Verlaufs der skalierten Bandenergien eine zusätzliche Robustheit gegen Störungen z.B. eines drahtlosen Kanals erhalten wird.

Das menschliche Gehör nimmt Audiosignale in einzelne Frequenzbänder aufgeteilt wahr. Entsprechend ist es vorteilhaft, die Energie eines Audiosignals bandweise zu bestimmen. Daher umfasst die erfindungsgemäße Vorrichtung eine Einrichtung zum Berechnen von Energiewerten für mehrere Frequenzbänder. Durch diese wird die spektrale Hüllkurve eines Audiosignals in einer technisch und psychoakustisch sinnvollen Näherung dargestellt.

Weiterhin beruht die vorliegende Erfindung auf der Erkenntnis, dass eine Skalierung der Energiewerte in mehreren Frequenzbändern sowohl im Einklang mit der menschlichen akustischen Wahrnehmung ist als auch eine technische Weiterverarbeitung der Energiewerte vereinfacht und den Ausgleich von spektralen Signalverzerrungen, die durch einen nichtidealen Frequenzgang eines Übertragungskanals verursacht werden, ermöglicht. Die menschliche akustische Wahrnehmung kann ein Audiosignal auch dann identifizieren, wenn einzelne Frequenzbänder in ihrer Leistung angehoben oder gedämpft sind. Daneben kann ein menschlicher Hörer ein Signal unabhängig von der Lautstärke identifizieren. Diese Fähigkeit eines menschlichen Hörers wird durch eine Einrichtung zur Skalierung nachgebildet. Auch für eine technische Anwendung ist eine Umskalierung der bandweisen Energiewerte hilfreich.

Schließlich können durch Anwenden einer Filteroperation auf die bandweisen Energiewerte Störungen in der gleichen Weise unterdrückt werden, wie dies durch die menschliche Hörwahrnehmung erfolgt. Die zeitliche Filterung der bandweisen Energiewerte ist dabei effizienter als eine herkömmliche Filterung des Audiosignals selbst und ermöglicht die Bildung eines gegenüber Signalstörungen robusteren Fingerabdrucks als dies bei herkömmlichen Vorrichtungen üblich ist.

Somit kann durch eine erfindungsgemäße Vorrichtung, die eine bandweise Bestimmung von Energiewerten in mehreren Frequenzbändern mit einer Skalierung und einer Filterung derselben verbindet, ein robustes Fingerabdrucksignal eines Audiosignals mit hohem Aussagewert erzeugt werden.

Ein Vorteil der vorliegenden Vorrichtung ist, dass der Fingerabdruck eines Audiosignals hierbei an das menschliche Gehör angepasst ist. Es fließen nicht nur rein physikalische, sondern im Wesentlichen psychoakustisch fundierte Merkmale in den Fingerabdruck ein. Audiosignale haben bei Anwendung einer erfindungsgemäßen Vorrichtung dann einen ähnlichen Fingerabdruck, wenn auch ein menschlicher Hörer diese als ähnlich beurteilen würde. Die Ähnlichkeit von Fingerabdrücken ist mit der subjektiv empfundenen Ähnlichkeit von Audiosignalen, wie sie ein menschlicher Hörer beurteilt, korreliert.

Ergebnis der genannten Überlegungen ist eine Vorrichtung zum Erzeugen eines Fingerabdrucksignals aufgrund eines Audiosignals, die es ermöglicht, auch Audiosignale, die Signalstörungen und Verzerrungen aufweisen, identifizieren und klassifizieren zu können. Insbesondere sind die Fingerabdrücke robust in Bezug auf Rauschen, kanalbedingte Störungen, Quantisierungseffekte und Artefakte aufgrund verlustbehafteter Datenkompression. Auch eine Verzerrung bezüglich des Frequenzgangs hat keinen schwerwiegenden Einfluss auf einen Fingerabdruck, der mit einer erfindungsgemäßen Vorrichtung erzeugt wird. Damit ist eine erfindungsgemäße Vorrichtung zur Erzeugung eines Fingerabdrucks zu einem Audiosignal für den Einsatz in Verbindung mit mobilen Kommunikationseinrichtungen, z.B. Mobiltelefonen nach dem GSM-, UMTS- oder DECT-Standard, gut geeignet.

Bei einem bevorzugten Ausführungsbeispiel können kompakte Fingerabdrücke mit einer Datenrate von etwa 1kbyte pro Minute Audiomaterial erzeugt werden. Diese Kompaktheit ermöglicht eine sehr effiziente Weiterverarbeitung der Fingerabdrücke in elektronischen Datenverarbeitungsanlagen.

Zusätzliche Vorteile können durch weitere Detailverbesserung des vorliegenden Verfahrens zur Bildung eines Fingerabdrucks eines Audiosignals erzielt werden.

Bei einem bevorzugten Ausführungsbeispiel wird für ein Segment eines Audiosignals eine diskrete Fourier-Transformation mittels einer schnellen Fourier-Transformation durchgeführt. Daraufhin werden die Beträge der Fourier-Koeffizienten quadriert und bandweise aufsummiert, um Energiewerte für ein Frequenzband zu erhalten. Ein Vorteil eines solchen Verfahrens ist, dass die Energie in einem Frequenzband mit geringem Aufwand berechnet werden kann. Weiterhin ist eine entsprechende Operation bereits in dem MPEG7-Standard enthalten, und muss daher nicht mehr separat implementiert werden. Dies verringert die Entwicklungskosten.

Bei einem weiteren bevorzugten Ausführungsbeispiel weisen die Frequenzbänder eine variable Bandbreite auf, wobei die Bandbreite bei hohen Frequenzen größer ist. Eine solche Vorgehensweise ist im Einklang mit dem menschlichen Gehör und psycho-akustischen Erkenntnissen.

Bei einem weiteren bevorzugten Ausführungsbeispiel umfasst die Einrichtung zum Skalieren eine Einrichtung zur Logarithmierung und eine der Einrichtung zur Logarithmierung nachgeschaltete Einrichtung zur Unterdrückung eines Gleichanteils. Eine solche Anordnung ist sehr vorteilhaft, da mit geringem Aufwand sowohl eine logarithmische Normierung als auch eine Eliminierung des Einflusses des Signalpegels in den Frequenzbändern erfolgt. Eine zeitlich konstante Veränderung des Signalpegels bringt bei der Logarithmierung lediglich einen Gleichanteil mit sich. Dieser kann durch eine geeignete Anordnung relativ einfach unterdrückt werden. Die logarithmische Normierung ist im übrigen sehr gut dem menschlichen Lautstärkeempfinden angepasst.

Bevorzugte Ausführungsbeispiele der vorliegenden Erfindung werden nachfolgend bezugnehmend auf die beiliegenden Zeichnungen näher erläutert. Es zeigen:
- Fig. 1: ein Blockschaltbild einer erfindungsgemäßen Vorrichtung zur Erzeugung eines Fingerabdrucksignals aus einem Audiosignal;
- Fig. 2: ein detailliertes Blockschaltbild eines weiteren Ausführungsbeispiels einer erfindungsgemäßen Vorrichtung zur Erzeugung eines Fingerabdrucksignals aus einem Audiosignal;
- Fig. 3: ein Ablaufdiagramm eines Ausführungsbeispiels eines Verfahrens zum Einrichten einer AudioDatenbank; und
- Fig. 4: ein Ablaufdiagramm eines Ausführungsbeispiels eines Verfahrens zum Gewinnen von Informationen aufgrund einer Audiosignal-Datenbank.

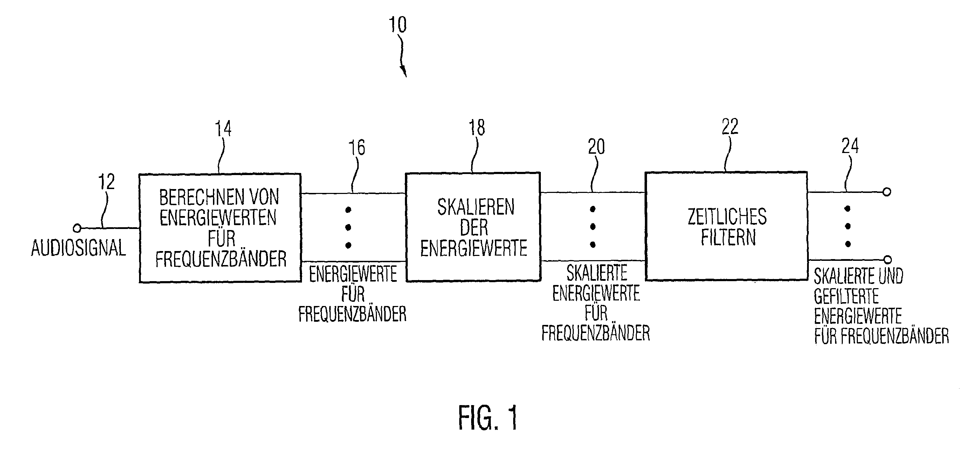

Fig. 1 zeigt ein Blockschaltbild einer erfindungsgemäßen Vorrichtung zur Erzeugung eines Fingerabdrucksignals aus einem Audiosignal, die in ihrer Gesamtheit mit 10 bezeichnet ist. Der Vorrichtung wird als Eingangssignal ein Audiosignal 12 zugeführt. In einer ersten Stufe 14 werden Energiewerte für Frequenzbänder berechnet, die dann in Form eines Vektors 16 von Energiewerten zur Verfügung stehen. In einer zweiten Stufe 18 werden die Energiewerte skaliert. Es steht sodann ein Vektor 20 von skalierten Energiewerten für mehrere Frequenzbänder zur Verfügung. In einer dritten Stufe 22 wird dieser Vektor zeitlich gefiltert. Als Ausgangssignal der Vorrichtung steht ein Vektor 24 von skalierten und gefilterten Energiewerten für mehrere Frequenzbänder an.

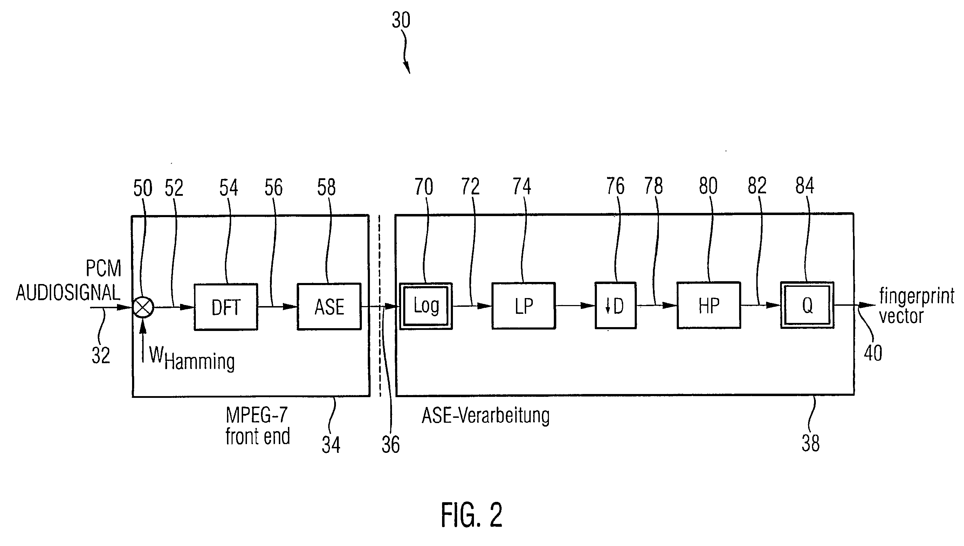

Fig. 2 zeigt ein detailliertes Blockschaltbild eines Ausführungsbeispiels einer erfindungsgemäßen Vorrichtung zur Erzeugung eines Fingerabdrucksignals aus einem Audiosignal, die in ihrer Gesamtheit mit 30 bezeichnet ist. Am Eingang der Vorrichtung liegt ein Pulsecode-moduliertes Audiosignal 32 an. Dieses wird einem MPEG-7 Frontend 34 zugeführt. Am Ausgang des MPEG-7 Frontends liegt eine Sequenz von Vektoren 36 an, deren Komponenten die Energien der entsprechenden Bänder darstellen. Diese Sequenz von Vektoren wird einer zweiten Stufe 38 zur Verarbeitung der spektralen Audio-Hüllkurve zugeführt. An deren Ausgang liegt eine Sequenz von Vektoren 40, die in ihrer Gesamtheit den Fingerabdruck des Audiosignals darstellen. Das MPEG-7 Frontend 34 ist Bestandteil des MPEG-7 Audio-Standards und umfasst eine Einrichtung 50 zur Fensterung des PCM-codierten Audiosignals 32. Am Ausgang der Fensterungseinrichtung 50 liegt eine Sequenz von Segmenten 52 des Audiosignals mit einer Länge von 30 ms an. Diese werden einer Einrichtung 54 zugeführt, die die Spektren der Segmente mittels einer diskreten Fourier-Transformation berechnet und an deren Ausgang Fourier-Koeffizienten 56 anliegen. Eine letzte Einrichtung 58 bildet die spektrale Audio-Hüllkurve ("Audio Spectrum Envelope", ASE) Dabei werden die Beträge der Fourier-Koeffizienten 56 quadriert und bandweise aufsummiert. Dies entspricht der Berechnung der Bandenergien. Die Breite der Bänder nimmt mit steigender Frequenz zu (logarithmische Bandeinteilung) und kann durch einen weiteren Parameter bestimmt werden. Somit ergibt sich für jedes Segment ein Vektor 36, dessen Einträge die Energie in einem Frequenzband eines 30 ms langen Segments darstellen. Das MPEG-7 Frontend zur Berechnung der bandweisen Spektral-Hüllkurve eines Audio-Segments ist Bestandteil des MPEG-7 Audio-Standards (ISO/IEC JTC1/SC29/WG 11 (MPEG): "Multimedia Content Description Interface - part 4: Audio", International Standard 15938-4, ISO/IEC, 2001).

Die mit dem MPEG-7 Frontend gewonnene Sequenz von Vektoren ist als solche im Hinblick auf eine robuste Klassifizierung von Audiosignalen ungeeignet. Eine weitere Stufe zur Verarbeitung der spektralen Audio-Hüllkurve ist daher notwendig, um die als Merkmal dienende Sequenz von Vektoren zu modifizieren, damit dieses eine höhere Robustheit und eine geringere Datenrate erhält.

Die Einrichtung 38 zur Verarbeitung der spektralen Audio-Hüllkurve weist als erste Stufe eine Einrichtung 70 zur Logarithmierung der bandweisen Energiewerte 36 auf. Die logarithmierten Energiewerte 72 werden dann einem Tiefpassfilter 74 zugeführt. Dem Tiefpassfilter 74 nachgeschaltet ist eine Einrichtung 76 zur Dezimation der Anzahl an Energiewerten. Die dezimierte Sequenz 78 aus Energiewerten wird einem Hochpassfilter 80 zugeführt. Die hochpassgefilterte Sequenz 82 von spektralen Energiewerten wird schließlich einem signalangepassten Quantisierer 84 übergeben. An dessen Ausgang liegt schließlich eine Sequenz von verarbeiteten spektralen Energiewerten 40, die in ihrer Gesamtheit den Fingerabdruck darstellen.

Aufbauend auf der Beschreibung der Struktur der Vorrichtung zur Erzeugung eines Fingerabdrucksignals aus einem Audiosignal wird nun die Funktionsweise im Detail beschrieben. Grundlage der erfindungsgemäßen Vorrichtung zur Erzeugung eines Fingerabdrucksignals aus einem Audio-Signal ist die Berechnung der Bandenergien in mehreren Frequenzbändern eines Audiosignal-Segments. Dies entspricht der Bestimmung der spektralen Audio-Hüllkurve. Bei dem gezeigten Ausführungsbeispiel wird dies durch das MPEG-7 Frontend 34 erreicht. Für dieses Ausführungsbeispiel wird es bevorzugt, dass die Breite der Bänder mit steigender Frequenz zunimmt und dass die Energiewerte der Frequenzbänder am Ausgang des MPEG-7 Frontends 34 als Vektor 36 von Bandenergiewerten zur Verfügung stehen. Eine derartige Signalaufbereitung entspricht dem menschlichen Gehör, bei dem die Wahrnehmung in mehrere Frequenzbänder aufgeteilt ist, deren Breite mit steigender Frequenz zunimmt. Somit wird der menschliche Gehöreindruck durch das MPEG-7 Frontend 34 in dieser Hinsicht nachempfunden.

In einem weiteren Verarbeitungsschritt folgt eine bandweise Normierung der Energiewerte. Die Vorrichtung zur Normierung umfasst dabei zwei Stufen, eine Einrichtung 70 zur Logarithmierung der Energiewerte und ein Hochpassfilter 80. Die Logarithmierung erfüllt dabei zwei Aufgaben. Eine Logarithmierung bildet einerseits die menschliche Wahrnehmung von Lautstärke ab. Gerade bei großen Lautstärken nimmt die subjektive Wahrnehmung durch den Menschen um einen bestimmten Betrag zu, wenn sich die Audioleistung gerade verdoppelt. Eine Logarithmiereinrichtung 70 zeigt genau das gleiche Verhalten. Weiterhin bringt die Logarithmiereinrichtung 70 den Vorteil, dass der Wertebereich für die Energiewerte in einem Band verkleinert wird, was eine technisch deutlich vorteilhafte Zahlendarstellung ermöglicht. Insbesondere ist es nicht nötig, eine Fließkomma-Darstellung zu verwenden, sondern eine Festkomma-Darstellung kann eingesetzt werden.

Es sollte weiterhin erwähnt werden, dass Logarithmierung hier nicht im streng mathematischen Sinne zu verstehen ist. Insbesondere bei kleineren Energien in einem Frequenzband würde eine Logarithmierung zu betragsmäßig sehr großen Werten führen. Dies ist weder technisch sinnvoll noch entspricht es dem Gehörempfinden des Menschen. Vielmehr ist es sinnvoll, für kleine Energiewerte eine näherungsweise lineare Charakteristik zu verwenden oder zumindest den Wertebereich nach unten hin zu beschränken. Dies entspricht wiederum der menschlichen Wahrnehmung, bei der für kleine Lautstärken eine Hörschwelle existiert, für große Lautstärken jedoch eine in etwa logarithmische Wahrnehmung der Schallleistung erfolgt. Es kann somit festgehalten werden, dass die Dynamik der Energiewerte, die erfahrungsgemäß einen sehr großen Wertebereich aufweisen, durch die Logarithmierung auf einen viel kleineren Wert komprimiert wird. Die Operation der Logarithmierung entsprechend der voran gegebenen Beschreibung entspricht somit näherungsweise einer spezifischen Lautheitsbildung. Die Wahl der Logarithmusbasis ist ohne Belang, da dies nur einer multiplikativen Konstante entspricht, die durch die weitere Signalbearbeitung, insbesondere durch eine abschließende Quantisierung, kompensiert werden kann.

Neben einer Kompression des Dynamikbereichs und einer Anpassung an das menschliche Gehör erfüllt die Skalierung weiterhin die Aufgabe, die Bildung eines Fingerabdrucks aus einem Audiosignal unabhängig von dem Pegel des Audiosignals zu machen. Zum Verständnis muss hierbei berücksichtigt werden, dass der Fingerabdruck sowohl aus einem ursprünglich zur Verfügung stehenden unverfälschten Signal als auch aus einem über einen Übertragungskanal übertragenen Signal gebildet werden kann. Dabei kann eine Veränderung der Lautstärke bzw. des Pegels auftreten. Außerdem werden bei Übertragung über eine Übertragungsstrecke mit nicht-konstantem Frequenzgang einzelne Frequenzanteile gedämpft bzw. verstärkt. Somit können zwei Signale mit gleichem Inhalt eine verschiedene spektrale Energieverteilung aufweisen. Im folgenden soll angenommen werden, dass die Frequenzgang-Verzerrung zwischen zwei Signalen zeitunabhängig ist. Ferner wird angenommen, dass die Verzerrung innerhalb eines Frequenzbandes näherungsweise konstant ist. In diesem Fall kann davon ausgegangen werden, dass sich die Energien in einem vorgegebenen Frequenzband für zwei Signale mit gleichem Audioinhalt nur um eine zeitlich konstante multiplikative Konstante unterscheiden. Die Operation des Logarithmierens bildet eine zeitliche konstante multiplikative Konstante auf einem zeitlich konstanten additiven Term ab. Somit erscheint nach der Logarithmierung der Energien eine Verstärkungs- bzw. Dämpfungskonstante, durch die sich zwei Signale unterscheiden, als konstanter additiver Term im Merkmalswert. Dieser wird durch die Anwendung eines Hochpassfilters 80, das insbesondere einen Gleichanteil unterdrückt, aus dem Signal weggefiltert. Auch andere einen Gleichanteil unterdrückende Filter können verwendet werden. Insbesondere sollte darauf hingewiesen werden, dass eine solche Anpassung bei der vorliegenden Anordnung für jedes Frequenzband separat erfolgt. Somit ist auch die Pegelnormierung für jedes Frequenzband unabhängig, und es kann eine spektrale Verzerrung eines Signals ausgeglichen werden. Dies entspricht im übrigen der Fähigkeit des menschlichen Gehörs, spektral verzerrte Audiosignale zu identifizieren.

Weiterhin umfasst die Vorrichtung zur Erzeugung eines Fingerabdrucksignals aus einem Audiosignal in dem hier vorliegenden Ausführungsbeispiel ein Tiefpaßfilter 74. Dieses filtert im Zeitbereich die Sequenz der Energiewerte für die Frequenzbänder. Die Filterung erfolgt wiederum separat für die Frequenzbänder. Eine Tiefpassfilterung ist sinnvoll, da die zeitlichen Folgen der logarithmierten Werte sowohl Anteile des zu identifizierenden Signals als auch Störungen enthalten. Die Tiefpassfilterung glättet den zeitlichen Verlauf der Energiewerte. Somit werden schnell veränderliche Anteile, die meist durch Störungen verursacht werden, aus der Sequenz der Energiewerte für die Frequenzbänder entfernt. Dies resultiert in einer besseren Unterdrückung von Störsignalen.

Gleichzeitig wird durch die Tiefpassfilterung mittels des Tiefpassfilters 74 die Informationsmenge, die verarbeitet werden muss, reduziert, wobei insbesondere die hochfrequenten Anteile entfernt werden. Aufgrund des Tiefpasscharakters des Signals kann dieses mittels einer dem Tiefpassfilter 74 nachgeschalteten Dezimationseinrichtung 76 um einen bestimmten Faktor D dezimiert werden, ohne Informationen zu verlieren ("Abtastheorem"). Das heißt, es wird nur noch eine geringere Zahl an Abtastwerten für die Energie in einem Frequenzband verwendet. Die Datenrate erniedrigt sich hierbei um den Faktor D.

Die Kombination von Tiefpassfilter 74 und Dezimationseinrichtung 76 erlaubt es somit nicht nur, Störungen durch Tiefpassfilterung zu unterdrücken, sondern sie ermöglicht es insbesondere, redundante Information zu unterdrücken und somit auch die Datenmenge für das Fingerabdrucksignal zu verringern. Es wird somit all die Information unterdrückt, die keinen direkten Einfluss auf den menschlichen Höreindruck hat. Der Dezimationsfaktor wird anhand der Tiefpassfrequenz des Filters bestimmt.

Schließlich ist es zweckmäßig, die so verarbeiteten Energiewerte in einer Quantisierungseinrichtung 84 signalangepasst zu quantisieren. Dabei werden den reellwertigen Energiewerten endliche ganzzahlige Werte zugeordnet. Die Quantisierungsintervalle sind hierbei ggf. ungleichförmig und von der Signalstatistik bestimmt. Alternativ kann es vorteilhaft sein, bei kleinen Werten kleine Quantisierungsintervalle und bei großen Werten große Quantisierungsintervalle zu verwenden. Insbesondere ergibt sich ein Vorteil durch die Zusammenschaltung eines Hochpassfilters 80 und einer Quantisierungseinrichtung 84. Das Hochpaßfilter 80 verringert den Wertebereich des Signals. Somit ist eine Quantisierung mit geringerer Auflösung möglich. Ebenso werden viele Werte auf eine kleine Zahl von Quantisierungsstufen abgebildet, was die Codierung des quantisierten Signals mit Hilfe von Entropiecodes ermöglicht und dadurch die Datenmenge reduziert.

Weiterhin kann eine signalangepasste Quantisierung dadurch erfolgen, dass für das Signal in einer Vorverarbeitungseinrichtung eine Amplitudenstatistik gebildet wird. Damit ist bekannt, welche Amplitudenwerte in dem Signal mit größter Häufigkeit vorkommen. Die Kennlinien der Quantisierer werden anhand der relativen Häufigkeiten der jeweiligen Werte bestimmt. Für häufig vorkommende Amplitudenwerte werden feine Quantisierungsstufen gewählt, während Amplitudenwerte bzw. die zugehörigen Amplitudenintervalle, die selten in dem Signal vorkommen, mit größeren Quantisierungsstufen quantisiert werden. Dies bringt den Vorteil, dass für ein gegebenes Signal mit einer vorbestimmten Amplitudenstatistik eine Quantisierung mit geringst möglichem Fehler (der typischerweise als Fehlerleistung oder Fehlerenergie gemessen wird) erzielt werden kann. Im Unterschied zu der vorher beschriebenen nichtlinearen Quantisierung, bei der die Größe der Quantisierungsstufen im wesentlichen proportional zu dem zugehörigen Signalwert ist, muss der Quantisierer bei der signalangepassten Quantisierung auf jedes Signal neu eingestellt werden, es sei denn, es wird davon ausgegangen, dass mehrere Signale eine sehr ähnliche Amplitudenstatistik aufweisen.

Eine signalangepasste Quantisierung der Merkmalsvektoren kann auch dadurch erfolgen, dass die Vektorkomponenten mit einem angepassten Vektorquantisierer quantisiert werden. Somit wird eine bestehende Korrelation zwischen den Komponenten implizit mitberücksichtigt.

Anstelle einer direkten Vektorquantisierung ist es auch möglich, die Vektoren vor der Quantisierung einer linearen Transformation zu unterziehen. Diese Transformation ist bevorzugterweise so ausgelegt, dass eine maximale Dekorrelation der transformierten Vektorkomponenten gewährleistet ist. Eine solche Transformation kann als eine Hauptachsentransformation berechnet werden. Bei dieser Operation wird die Signalenergie typischerweise in den ersten transformierten Komponenten konzentriert, so dass die letzten Werte ignoriert werden können. Dies entspricht einer Dimensionsreduktion. Die transformierten Vektoren werden anschließend skalar quantisiert. Dies erfolgt bevorzugterweise signalangepasst für alle Komponenten.

Es wurde somit ein Ausführungsbeispiel einer Vorrichtung beschrieben, mit deren Hilfe aus einem Audiosignal ein Fingerabdrucksignal erzeugt werden kann. Ein wesentlicher Vorteil der vorgestellten Vorrichtung liegt einerseits in der sehr hohen Robustheit, die es ermöglicht, GSM-codierte Audiosignale identifizieren zu können und andererseits in der geringen Größe der Signaturen. Es können Signaturen mit einer Rate von etwa 1 kByte pro Minute Audiomaterial erzeugt werden. Bei einer durchschnittlichen Liedlänge von etwa 4 Minuten ergibt dies eine Signaturgröße, von 4 kByte pro Lied. Diese Kompaktheit ermöglicht es unter anderem, die Anzahl der Referenzsignaturen im Hauptspeicher eines einzelnen Rechners zu erhöhen. Somit können auf neueren Rechnern eine Million Referenzsignaturen problemlos im Hauptspeicher untergebracht werden.

Die anhand von Fig. 2 beschriebene Ausführungsform stellt ein bevorzugtes Ausführungsbeispiel der vorliegenden Erfindung dar. Allerdings ist es möglich, eine große Vielfalt von Änderungen vorzunehmen, ohne von dem Kerngedanken der Erfindung abzuweichen.

Es kann eine Vielzahl von verschiedenen Einrichtungen verwendet werden, um die Energien in den Frequenzbändern zu bestimmen. Das MPEG-7 Frontend 34 kann durch eine beliebige andere Vorrichtung ersetzt werden, solange gewährleistet ist, dass die Energiewerte in mehreren Frequenzbändern in den Segmenten eines Audiosignals an ihrem Ausgang zur Verfügung stehen. Dabei kann insbesondere auch die Einteilung der Frequenzbänder verändert werden. Anstelle einer logarithmischen Bandeinteilung kann eine beliebige Bandeinteilung verwendet werden, wobei eine solche Bandeinteilung bevorzugt ist, die dem menschlichen Gehör angepasst ist. Die Länge der Segmente, in die das Audiosignal aufgeteilt wird, kann ebenfalls variiert werden. Um die Datenrate gering zu halten, werden Segmentlängen von mindestens 10 ms bevorzugt.

Für die Skalierung der Energiewerte in den Frequenzbändern steht eine Vielzahl von Verfahren zur Verfügung. Anstelle einer bei dem obigen Ausführungsbeispiel verwendeten Logarithmierung der spektralen Bandenergien mit anschließender Hochpassfilterung kann hierbei z.B. eine näherungsweise Logarithmierung erfolgen. Weiterhin kann der Wertebereich der Ausgangswerte des Logarithmierers beschränkt sein. Dies bringt den Vorteil, dass insbesondere bei sehr kleinen Energiewerten das Ergebnis der Logarithmierung in einem beschränkten Wertebereich liegt. Insbesondere kann auch die Einrichtung 70 zur Logarithmierung durch eine dem menschlichen Lautstärkeempfinden noch besser angepasste Einrichtung ersetzt werden. Eine solche verbesserte Einrichtung kann insbesondere die untere Hörschwelle des Menschen sowie das subjektive Lautstärkeempfinden berücksichtigen.

Weiterhin kann die Normierung der spektralen Bandenergien durch die Gesamtenergie erfolgen. Bei einer solchen Ausführungsform werden die Energiewerte in den einzelnen Frequenzbändern durch einen Normierungsfaktor dividiert, der entweder ein Maß für die Gesamtenergie des Spektrums oder für die Gesamtenergie der betrachteten Bänder darstellt. Bei dieser Form der Normierung muss keine Hochpassfilterung mehr ausgeführt werden, und eine Logarithmierung ist nicht nötig. Vielmehr ist die Gesamtenergie in jedem Segment konstant. Ein solches Vorgehen ist insbesondere dann von Vorteil, wenn in einzelnen Frequenzbändern nur eine sehr geringe mittlere Energie vorhanden ist. Ein solches Normierungsverfahren erhält das Verhältnis der Energien in verschiedenen Bändern. Dies kann bei manchen Audiosignalen ein wichtiges Merkmal darstellen, und es ist vorteilhaft, das Merkmal zu erhalten. Eine Entscheidung, welche Art der Normierung zweckmäßig ist, kann in Folge eines unverfälschten, d.h. nicht bezüglich des Frequenzgangs verzerrten, Audiosignals getroffen werden. Die Normierung der spektralen Bandenergien durch die Gesamtenergie wurde z.B. in Y. Wang, Z. Liu and J. C. Huang: "Multimedia Content Analysis", IEEE Signal Processing Magazine, 2000, vorgeschlagen.

Weiterhin ist es möglich, eine lokale spektrale Normierung durchzuführen. Eine solche ist in J. Soo Seo, J. Haitsma und T. Kalker: "Linear Speed-Change Resilient Audio Fingerprinting", Proceedings 1st IEEE Benelux Workshop on Model Based Processing and Coding of Audio", Leuven, Belgium, 2002 beschrieben.

Für die zeitliche Glättung der Energiewerte in aufeinander folgenden Segmenten können verschiedene Verfahren verwendet werden. In dem vorher beschriebenen Ausführungsbeispiel wird ein digitales Tiefpassfilter verwendet. Weiterhin ist es möglich, für die Energiewerte Modulationsspektren zu berechnen. Niederfrequente Modulationskoeffizienten beschreiben hierbei den geglätteten Verlauf der spektralen Energiewerte. Der Einsatz von Modulationsspektren zur Audioerkennung ist z.B. bei S. Sukittanon and L. Atlas: "Modulation Frequency Features for Audio Fingerprinting", IEEE ICASSP 2002, pp. 1773-1776, Orlando, Florida, USA, 2002 beschrieben. Daneben ist die Glättung des zeitlichen Verlaufs der Energiewerte in aufeinander folgenden Segmenten dadurch möglich, dass ein gleitender Mittelwert berechnet wird. Somit wird ein Mittelwert von einer bestimmten Anzahl von aufeinander folgenden Merkmalen berechnet. Dies wird z.B. in dem MPEG-7 Standard durch die "Scalable Series" ermöglicht. Diese Art der Glättung hat jedoch den Nachteil, dass sie im signaltheoretischen Sinne Nebeneffekte (Aliasing) mit sich ziehen kann. Dieser Effekt kann jedoch durch einen richtig dimensionierten Tiefpassfilter weitestgehend unterdrückt werden.

Weiterhin ist es möglich, auf die Dezimationsstufe zu verzichten. Dies ist insbesondere dann sinnvoll, wenn die verarbeiteten Segmente des Audiosignals sehr lange sind. Die Datenrate ist in diesem Fall schon hinreichend gering, und eine Dezimierung ist nicht mehr nötig. Der Vorteil einer solchen Anordnung besteht darin, dass in der gesamten Vorrichtung zur Ableitung eines Fingerabdrucks aus den spektralen Energiewerten die gleiche Datenrate anliegt. Dies erleichtert eine technische Implementierung, insbesondere in Form eines Computerprogramms.

Das Hochpassfilter 80 kann in einem weiten Bereich variiert werden. Eine sehr einfache Ausführungsform besteht darin, jeweils die Differenzen von zwei aufeinander folgenden Werten zu verwenden. Eine solche Ausführungsform hat den Vorteil, dass sie technisch sehr einfach zu realisieren ist.

Die Einrichtung 84 zur Quantisierung kann in einem weiten Bereich modifiziert werden. Sie ist nicht zwingend erforderlich und kann in einem Ausführungsbeispiel entfallen. Dies verringert den Aufwand bei der Implementierung der erfindungsgemäßen Vorrichtung. Auf der anderen Seite kann bei einem weiteren Ausführungsbeispiel eine an das Signal angepasste Quantisierungseinrichtung verwendet werden, bei der die Quantisierungsintervalle an die Amplitudenstatistik eines Signals angepasst sind. Damit wird der Quantisierungsfehler für ein Signal minimal. Auch eine Vektorquantisierung kann an das Signal angepasst sein bzw. mit einer linearen Transformation kombiniert werden.

Weiterhin ist es möglich, die Quantisierungseinrichtung mit einer Vorrichtung zur Hochpassfilterung bzw. zur Differenzenbildung zu kombinieren. Eine Differenzenbildung verringert in vielen Fällen den Wertebereich der zu quantisierenden Signale. Veränderungen der Energiewerte werden betont, zeitlich konstante Signale werden zu null gemacht. Weist ein Signal in einer hinreichend großen Anzahl von zeitlich aufeinander folgenden Segmenten nahezu unveränderte Werte auf, so ist die Differenz näherungsweise null. Das Ausgangssignal des Quantisierers ist entsprechend auch null. Wird nun zur Codierung der quantisierten Signale ein Entropiecode verwendet, bei dem häufig vorkommenden Signalwerten ein kurzes Symbol zugeordnet wird, so kann der Signalverlauf mit einem minimalen Aufwand an Speicherplatz abgespeichert werden.

Bei einem weiteren Ausführungsbeispiel können die skalaren Quantisierer, die die verarbeiteten Energiewerte für jedes Frequenzband einzeln quantisieren, durch einen Vektor-Quantisierer ersetzt werden. Ein solcher ordnet einem Vektor, der die verarbeiteten Energiewerte in den verwendeten Frequenzbändern (z.B. in vier Frequenzbändern) umfasst, einen ganzzahligen Indexwert zu. Das Ergebnis ist für jeden Vektor von Energiewerten nur noch ein skalarer Wert. Damit ist die anfallende Datenmenge geringer als bei der getrennten Quantisierung der Energiewerte in den Frequenzbändern, da Korellationen innerhalb der Vektoren berücksichtigt werden.

Des weiteren kann auch eine Form der Quantisierung verwendet werden, bei der die Breite von Quantisierungsstufen für große Energiewerte größer ist als für kleine Energiewerte. Das Ergebnis ist, dass auch kleine Signale mit zufriedenstellender Auflösung quantisiert werden können. Es ist insbesondere möglich, die Quantisierungseinrichtung so auszulegen, dass für kleine und große Energiewerte der maximale relative Quantisierungsfehler in etwa gleich groß ist.

Daneben kann bei einem weiteren Ausführungsbeispiel die Reihenfolge der Verarbeitungseinrichtungen verändert werden. Insbesondere können Einrichtungen, die eine lineare Verarbeitung der Energiewerte bewirken, vertauscht werden. Es ist jedoch zweckmäßig, dass eine gegebenenfalls vorhandene Dezimationseinrichtung unmittelbar nach einem Tiefpaßfilter angeordnet ist. Eine solche Kombination von Tiefpassfilterung und Dezimation ist sinnvoll, da damit Störeinflüsse durch Unterabtastung am wirkungsvollsten vermieden werden können. Weiterhin muss ein Hochpassfilter nach der Logarithmierungseinrichtung angeordnet sein, um den bei der Logarithmierung eventuell anfallenden Gleichanteil unterdrücken zu können.

Die erfindungsgemäße Vorrichtung zur Erzeugung eines Fingerabdrucksignals aus einem Audiosignal kann vorteilhaft für die Einrichtung und den Betrieb einer Audiodatenbank eingesetzt werden.

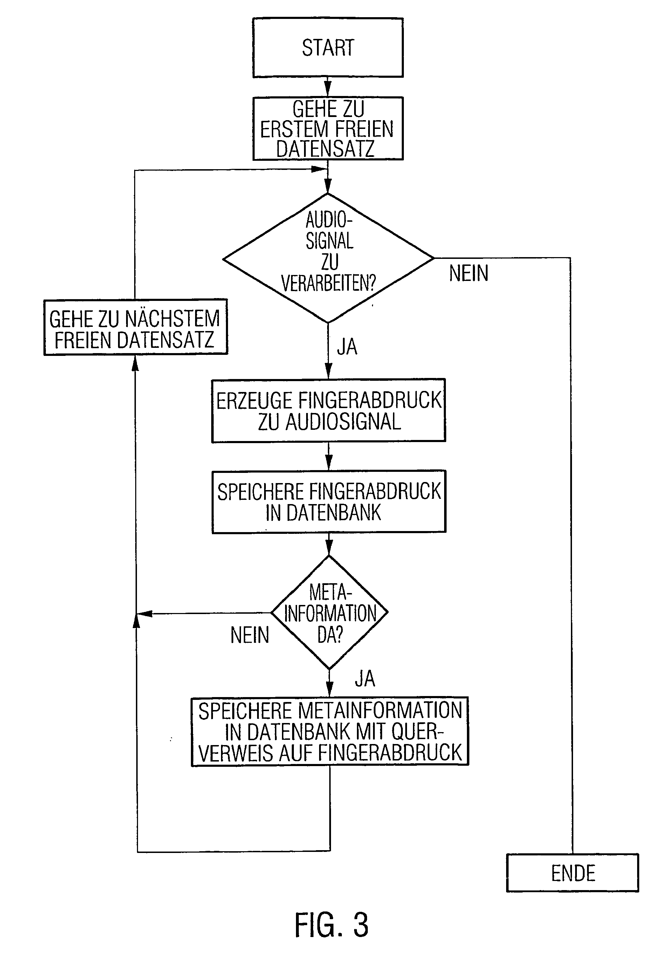

Fig. 3 zeigt ein Ablaufdiagramm eines Ausführungsbeispiels eines Verfahrens zum Einrichten einer Audio-Datenbank. Beschrieben ist hier die Vorgehensweise zum Erzeugen eines neuen Datensatzes aufgrund eines Audiosignals. Nach dem Start' des Verfahrens wird zuerst der erste freie Datensatz gesucht. Anschließend wird überprüft, ob ein Audiosignal zur Verarbeitung anliegt. Ist dies der Fall, so wird zu dem Audiosignal ein Fingerabdrucksignal erzeugt und dies in der Datenbank abgespeichert. Liegen weiterhin zusätzlich Informationen (sogenannte Metadaten) zu dem Audiosignal vor, so werden diese ebenfalls in die Datenbank eingespeichert und ein Querverweis auf den Fingerabdruck angelegt. Damit ist das Einspeichern eines Datensatzes beendet. In der Datenbankanwendung wird dann ein Zeiger auf den nächsten freien Datensatz gesetzt. Sind weitere Audiosignale zu verarbeiten, so wird das beschriebene Verfahren mehrmals durchlaufen. Sind keine Audiosignale mehr zu verarbeiten, so wird das Verfahren beendet.

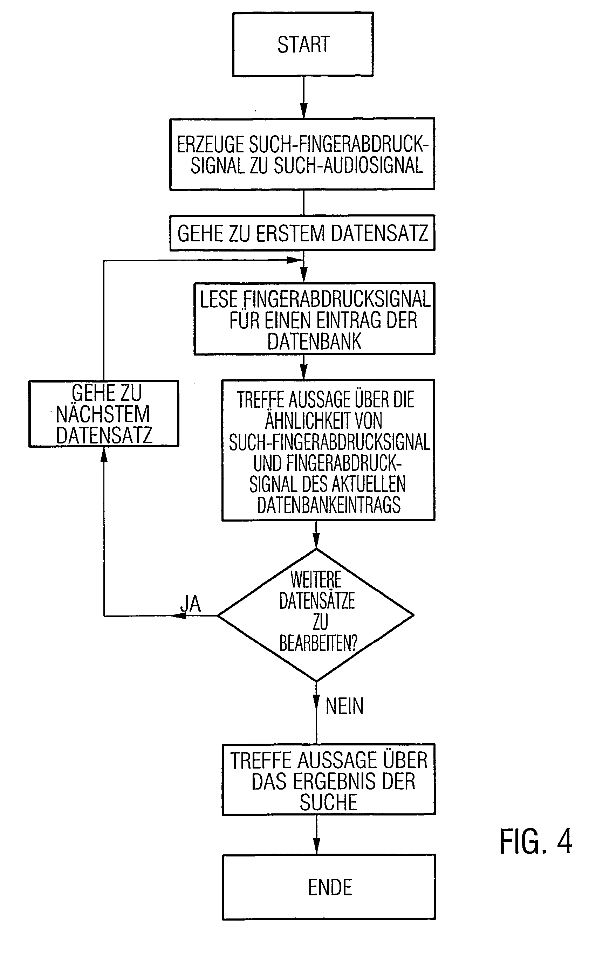

Fig. 4 zeigt ein Ablaufdiagramm eines Ausführungsbeispiels eines Verfahrens zum Gewinnen von Informationen aufgrund einer Audiosignal-Datenbank. Ziel dieses Verfahrens ist es, zu einem vorgegebenen Such-Audiosignal Informationen aus einer Datenbank zu gewinnen. In einem ersten Schritt wird hierbei aus dem Such-Audiosignal ein Such-Fingerabdruck erzeugt. Hierbei wird eine Vorrichtung bzw. ein Verfahren gemäß der vorliegenden Erfindung verwendet. Anschließend wird der Datensatz-Zeiger der Datenbank auf den ersten zu durchsuchenden Datensatz gerichtet. Das in der Datenbank gespeicherte Fingerabdrucksignal für einen Datenbankeintrag wird dann aus der Datenbank ausgelesen. Aufgrund des Such-Fingerabdrucksignals und des ausgelesenen Fingerabdrucksignals des aktuellen Datenbankeintrags wird nun eine Aussage über die Ähnlichkeit der Audiosignale getroffen. Sind weitere Datensätze zu bearbeiten, so wird das Auslesen des Fingerabdrucksignals und der Vergleich mit dem Such-Fingerabdrucksignal für die weiteren Datensätze wiederholt. Sind alle zu durchsuchenden Datensätze abgearbeitet, so wird eine Aussage über das Ergebnis der Suche getroffen, wobei die für jeden einzelnen der zu durchsuchenden Datensätze getroffenen Aussagen berücksichtigt werden.

Bei einer bevorzugten Ausführungsform wird das erfindungsgemäße Verfahren zur Durchsuchung einer Audiosignal-Datenbank um die Ausgabe einer zu dem Audiosignal gehörigen Metainformation erweitert. Dies ist beispielsweise in Verbindung mit Musikstücken sinnvoll. Anhand eines gegebenen Ausschnitts aus einem Musiktitel kann mittels des beschriebenen Verfahrens eine Datenbank durchsucht werden. Sobald eine hinreichende Ähnlichkeit des unbekannten Musiktitels mit einem in der Datenbank erfassten Musiktitel erkannt wird, können die in der Datenbank gespeicherten Metadaten ausgegeben werden. Diese können beispielsweise den Titel und Interpreten des Musikstücks, Informationen über das Album, auf dem der Titel enthalten ist, sowie Informationen über Bezugsquellen und Urheberrechte umfassen. Damit ist es möglich, ausgehend von einem Ausschnitt eines Musikstücks alle benötigten Informationen darüber zu erhalten.

In einer Erweiterung des beschriebenen Verfahrens kann die Datenbank auch die eigentlichen Musikdaten enthalten. Damit kann ausgehend von der Kenntnis eines Ausschnitts eines Musikstücks das gesamte Musikstück zurückgeliefert werden.

Das beschriebene Verfahren zum Betrieb einer Audiodatenbank ist freilich nicht auf Musikstücke beschränkt. Vielmehr können alle Arten von natürlichen oder technischen Geräuschen entsprechend klassifiziert werden. Eine auf einem erfindungsgemäßen Verfahren basierende Audiodatenbank kann somit entsprechende Metadaten zurückliefern und die Erkennung verschiedenster akustischer Signale ermöglichen.

Die anhand der Figuren 3 und 4 beschriebenen Verfahren zur Einrichtung und zum Betrieb einer Audiosignal-Datenbank unterscheiden sich von herkömmlichen Datenbanken im wesentlichen durch die Art und Weise, auf die ein Fingerabdrucksignal erzeugt wird. Das erfindungsgemäße Verfahren zur Erzeugung eines Fingerabdrucksignals ermöglicht die Generierung eines gegenüber Störeinflüssen sehr robusten Fingerabdrucksignals auf der Basis des Inhalts eines Audiosignals. Somit ist die Wiedererkennung eines vorher in der Datenbank eingespeicherten Audiosignals auch dann mit hoher Zuverlässigkeit möglich, wenn dem zum Vergleich herangezogenen Audiosignal Störungen überlagert sind oder dieses in seinem Frequenzgang verzerrt ist. Weiterhin ist die Größe eines erfindungsgemäßen Fingerabdrucksignals nur etwas 4 kByte pro Lied. Diese Kompaktheit bringt den Vorteil, dass die Anzahl der Referenzsignaturen im Hauptspeicher eines einzelnen Rechners gegenüber anderen Verfahren erhöht ist. Auf einem modernen Rechner können eine Million an Fingerabdrucksignalen im Hauptspeicher untergebracht werden. Somit ist die Suche nach einem Audiosignal nicht nur sehr zuverlässig, sondern kann auch sehr schnell und resourceneffizient durchgeführt werden.

Die anhand von Fig. 3 und Fig. 4 beschriebenen Abläufe können in einem weiten Bereich variiert werden. Insbesondere kann jedes zur Einrichtung und zum Betrieb einer Datenbank geeignete Verfahren eingesetzt werden, solange sichergestellt ist, dass das erfindungsgemäße Fingerabdrucksignal verwendet wird. So ist es beispielsweise in einzelnen Lösungen denkbar, das Fingerabdrucksignal aus der Datenbank erst dann zu erzeugen, wenn es wirklich benötigt wird. Dies ist dann von Vorteil, wenn eine Audio-Datenbank mehrere Aufgaben gleichzeitig erfüllt, und der Vergleich zweier Audiosignale nur ausnahmsweise erforderlich ist. Weiterhin können zusätzliche Suchkriterien ohne Probleme einbezogen werden. Weiterhin ist es möglich, Einträge der Datenbank aufgrund des Fingerabdrucksignals einer Klasse von ähnlichen Audiosignalen zuzuordnen und die Informationen über die Zugehörigkeit zu einer Klasse in der Datenbank abzulegen.

Die vorliegende Erfindung schafft somit eine Vorrichtung und ein Verfahren zum Erzeugen eines Fingerabdrucksignals aus einem Audiosignal sowie Vorrichtungen und Verfahren, die es ermöglichen, aufgrund dieses Fingerabdrucks ein Audiosignal zu charakterisieren bzw. eine Datenbank einzurichten und zu betreiben. Die Erzeugung des Fingerabdrucksignals berücksichtigt hierbei sowohl die für eine technische Realisierung relevanten Aspekte wie einen geringen Implementierungsaufwand, eine geringe Größe des Fingerabdrucksignals und Robustheit gegenüber Störungen als auch psycho-akustische Phänomene. Das Ergebnis ist ein bezüglich des Datenvolumens sehr kleines Fingerabdrucksignal, das den Inhalt eines Audiosignals charakterisiert und ein Wiedererkennen des Audiosignals mit hoher Zuverlässigkeit ermöglicht. Der Einsatz des Fingerabdrucksignals ist sowohl zur Klassifizierung eines Audiosignals als auch für Datenbankanwendungen geeignet.

Abhängig von den Gegebenheiten kann das erfindungsgemäße Verfahren zum Erzeugen eines Fingerabdrucksignals aus einem Audiosignal in Hardware oder in Software implementiert werden. Die Implementation kann auf einem digitalen Speichermedium, insbesondere einer Diskette oder CD mit elektronisch auslesbaren Steuersignalen, erfolgen, die so mit einem programmierbaren Computersystem zusammenwirken können, dass das entsprechende Verfahren ausgeführt wird. Allgemein besteht die Erfindung somit auch in einem Computer-Programm-Produkt mit einem auf einem maschinenlesbaren Träger gespeicherten Programmcode zur Durchführung des erfindungsgemäßen Verfahrens, wenn das Computer-Programm-Produkt auf einem Rechner abläuft. In anderen Worten ausgedrückt kann die Erfindung somit als ein Computer-Programm mit einem Programmcode zur Durchführung des Verfahrens realisiert werden, wenn das Computer-Programm auf einem Computer abläuft.

Weiterhin kann die vorliegende Erfindung durch eine Vielzahl von Detailverbesserungen weiterentwickelt werden.

Bei einem Ausführungsbeispiel hat ein Segment des Audiosignals eine zeitliche Länge von mindestens 10 ms. Eine solche Ausführung reduziert die Anzahl der zu bildenden Energiewerte in den einzelnen Frequenzbändern gegenüber Verfahren, die eine kürzere Segmentlänge verwenden. Die anfallende Datenmenge ist geringer und die nachfolgende Bearbeitung der Daten erfordert einen geringeren Aufwand. Dennoch hat es sich gezeigt, dass eine Segmentlänge von etwa 20 ms im Hinblick auf die menschliche Wahrnehmung klein genug ist. Kürzere Audio-Anteile in einem Frequenzband treten in typischen Audiosignalen nicht auf und tragen auch zur menschlichen Wahrnehmung eines Audiosignal-Inhalts kaum bei.

Bei einem Ausführungsbeispiel ist die Einrichtung zum Skalieren ausgelegt, um einen Wertebereich der Energiewerte zu komprimieren, so dass ein Wertebereich von komprimierten Energiewerten kleiner ist als ein Wertebereich von nichtkomprimierten Energiewerten. Eine solche Ausführungsform bietet den Vorteil, dass der Dynamikbereich der Energiewerte verringert wird. Dies ermöglicht eine einfache Zahlendarstellung. Insbesondere wird es dadurch vermieden, eine Fließkomma-Darstellung verwenden zu müssen. Weiterhin berücksichtigt ein solches Vorgehen eine auch im menschlichen Ohr stattfindende Dynamikkompression.

Bei einem weiteren Ausführungsbeispiel kann die Skalierung mit einer Normierung der Energiewerte einhergehen. Wird eine Normierung durchgeführt, so wird damit die Abhängigkeit der Energiewerte von dem Aussteuerpegel des Audiosignals aufgehoben. Dies entspricht im wesentlichen der Fähigkeit des menschlichen Gehörs, sich an laute und leise Signale gleichermaßen anzupassen, und die inhaltliche Übereinstimmung zwischen zwei Audiosignalen unabhängig von der aktuellen Wiedergabelautstärke festzustellen.

Gemäß einem Ausführungsbeispiel ist es entweder möglich, den Wertebereich auf ein Intervall zwischen einer unteren Grenze und einer oberen Grenze einzuschränken oder die Energiewerte zu logarithmieren. Beide Vorgehensweisen führen zu robusten Fingerabdrücken eines Audiosignals. Die Logarithmierung zeigt dabei eine engere Verwandtschaft mit den Eigenschaften der menschlichen Hörwahrnehmung auf.

Bei einem Ausführungsbeispiel wird die Einrichtung zum Skalieren ausgelegt, um die Energiewerte entsprechend dem menschlichen Lautstärkeempfinden zu skalieren. Ein solches Vorgehen bietet den Vorteil, dass sowohl leise als auch laute Signale sehr präzise entsprechend dem menschlichen Wahrnehmungsvermögen beurteilt werden.

Gemäß einem bevorzugten Ausführungsbeispiel ist die Einrichtung zum Skalieren der Energiewerte ausgelegt, um eine bandweise Skalierung der Energiewerte durchzuführen. Die bandweise Skalierung entspricht hier der Fähigkeit des Menschen, ein Audiosignal auch dann zu erkennen, wenn es bezüglich des Frequenzgangs verzerrt ist.

Bei einem Ausführungsbeispiel erfolgt die Unterdrückung eines Gleichanteils durch ein der Einrichtung zur Logarithmierung nachgeschaltetes Hochpassfilter. Dies ermöglicht es, in allen Frequenzbändern innerhalb eines vorbestimmten Toleranzbereichs gleiche Aussteuerungspegel zu erzielen. Der für eine Auswertung der spektralen Energiewerte zulässige Toleranzbereich beträgt dabei etwa ± 3 dB.

Bei einem weiteren Ausführungsbeispiel ist die Einrichtung zum Skalieren ausgelegt, um eine Normierung der Energiewerte durch die Gesamtenergie durchzuführen. Durch eine solche Anordnung kann die Abhängigkeit vom Signalpegel genau wie bei der bandweisen Normierung eliminiert werden.

Bei einem weiteren Ausführungsbeispiel umfasst die Einrichtung zum zeitlichen Filtern der Folge von skalierten Vektoren eine Einrichtung, die ausgelegt ist, um eine zeitliche Glättung der Folge von skalierten Vektoren zu erzielen. Dies ist vorteilhaft, da Störungen auf dem Audiosignal meist in einer schnellen Veränderung der Energiewerte in den einzelnen Frequenzbändern resultieren. Informationstragende Anteile verändern sich im Vergleich dazu meist langsamer. Dies liegt in der Charakteristik von Audiosignalen, die insbesondere ein Musikstück repräsentieren, begründet.

Die Einrichtung zum zeitlichen Glätten der Folge von skalierten Vektoren ist bei einem Ausführungsbeispiel ein Tiefpassfilter mit einer Grenzfrequenz von weniger als 10 Hz. Eine solche Dimensionierung beruht auf der Erkenntnis, dass sich die informationstragenden Merkmale eines Sprach- oder Musiksignals vergleichsweise langsam, d.h. auf einer Zeitskala von mehr als 100 ms ändern.

Bei einem weiteren Ausführungsbeispiel umfasst die Einrichtung zum zeitlichen Filtern der Folge von skalierten Vektoren eine Einrichtung zur Bildung der Differenz zwischen zwei zeitlich aufeinander folgenden Energiewerten. Dies ist eine effiziente Implementierung eines Hochpassfilters.

Bei einem weiteren Ausführungsbeispiel weist die Vorrichtung zum Erzeugen eines Fingerabdrucksignals aus einem Audiosignal ein Tiefpassfilter sowie eine mit dem Ausgang des Tiefpassfilters verbundene Dezimationseinrichtung auf. Diese ist ausgelegt, um die Zahl der aus dem Audiosignal hergeleiteten Vektoren so zu verringern, dass ein Nyquist-Kriterium erfüllt ist. Eine solche Ausführungsform beruht wiederum auf der Erkenntnis, dass nur zeitlich langsame Änderungen der Energiewerte in den einzelnen Frequenzbändern einen hohen Informationsgehalt über das zu klassifizierende Audiosignal aufweisen. Entsprechend können schnelle Änderungen der Energiewerte durch ein Tiefpassfilter unterdrückt werden. Damit weist die Folge der Energiewerte für ein Frequenzband nur noch niederfrequente Anteile auf. Entsprechend ist eine Reduzierung der Abtastrate gemäß dem Abtasttheorem möglich. Nach der Dezimierung umfasst die skalierte und gefilterte Folge von Vektoren nur noch einen Vektor pro D Segmente anstatt wie ursprünglich einen Vektor pro Segment. D ist dabei der Dezimationsfaktor. Die Konsequenz eines solchen Vorgehens ist eine Verringerung der Datenrate des Fingerabdruck-Signals. Somit kann die Entfernung redundanter Information zugleich mit einer Reduktion der Datenmenge kombiniert werden. Ein solches Vorgehen verkleinert den resultierenden Fingerabdruck eines gegebenen Audiosignals und trägt damit zu einer effizienten Nutzung der erfindungsgemäßen Vorrichtung bei.

Bei einem weiteren Ausführungsbeispiel umfasst die erfindungsgemäße Vorrichtung eine Einrichtung zur Quantisierung. Damit ist es möglich, zusätzlich zur Skalierung eine zweite Umsetzung des Wertebereichs der Energiewerte vorzunehmen.

Bei einem weiteren Ausführungsbeispiel ist der Einrichtung zur Quantisierung ein Hochpassfilter vorgeschaltet, das ausgelegt ist, um die Beträge der zu quantisierenden Werte zu verringern. Dies ermöglicht eine Verringerung der Anzahl an Bits, die bei einem nicht signalangepassten Quantisierer zur Darstellung dieser Werte nötig sind. Somit reduziert sich die Datenrate. Bei einem signalangepassten Quantisierer hängt die Anzahl von Bits nicht von den Beträgen der zu quantisierenden Werte ab.

Ferner wird eine Entropiecodierung bevorzugt. Dabei werden häufig vorkommenden Werten kurze Codeworte zugeordnet, während selten vorkommenden Werten lange Codeworte zugeordnet werden. Das Ergebnis ist eine weiter verringerte Datenmenge.

Bei einem weiteren Ausführungsbeispiel kann die Einrichtung zur Quantisierung so ausgelegt sein, dass die Breite von Quantisierungsstufen für große Energiewerte größer ist als für kleine Energiewerte. Auch dies bringt eine Reduzierung der Anzahl an benötigten Bits zur Darstellung eines Energiewerts, wobei sehr kleine Signale weiterhin mit hinreichender Genauigkeit repräsentiert werden.

Insbesondere kann bei einem Ausführungsbeispiel die Einrichtung zur Quantisierung so ausgelegt sein, dass der maximale relative Quantisierungsfehler für große und kleine Energiewerte innerhalb eines Toleranzbereichs gleich ist. Der relative Quantisierungsfehler ist hierbei beispielsweise als das Verhältnis von absolutem Quantisierungsfehler für einen Energiewert und unquantisiertem Energiewert definiert. Das Maximum wird in einem Quantisierunginterval gebildet. Als Toleranzbereich ist beispielsweise ein Intervall von +/-3dB um einen vorgegebenen Wert verwendbar. Der maximale relative Quantisierungsfehler hängt dabei auch von der Bitbreite des Quantisierers ab.

Das beschriebene Ausführungsbeispiel stellt ein Beispiel für eine signalangepasste Quantisierung dar. Im Bereich der Signalverarbeitung ist aber noch eine Vielzahl von weiteren Formen der signalangepassten Quantisierung bekannt. In der erfindungsgemäßen Vorrichtung kann jede der Ausführungsformen verwendet werden, solange sichergestellt ist, dass sie an die statistischen Eigenschaften der gefilterten Energiewerte angepasst ist.

Bei einem Ausführungsbeispiel kann die Einrichtung zur Quantisierung so ausgelegt sein, dass die Breite von Quantisierungsstufen für seltene Energiewerte größer ist als für häufige Energiewerte. Auch dies bringt eine Reduzierung der Anzahl an benötigten Bits zur Darstellung eines Energiewerts bzw. einen geringeren Quantisierungsfehler.

Bei einem weiteren Ausführungsbeispiel ist die Einrichtung zur Quantisierung so ausgelegt, dass sie einem Vektor von bearbeiteten Energiewerten ein Symbol zuordnet. Dies stellt einen Vektor-Quantisierer dar. Mit Hilfe eines solchen wird eine weitere Reduktion der Datenmenge ermöglicht.

Schließlich ist festzuhalten, dass die erfindungsgemäße Vorrichtung bzw. das erfindungsgemäße Verfahren ein sehr breites Einsatzgebiet aufweist. Insbesondere lässt sich das hier beschriebene Konzept zur Erzeugung eines Fingerabdrucks in mustererkennenden Systemen einsetzen, um Signale zu identifizieren oder zu charakterisieren. Weiterhin ist das Konzept auch in Verbindung mit Verfahren einsetzbar, die Ähnlichkeiten bzw. Abstände zwischen Datensätzen bestimmen. Dies können beispielsweise Datenbankanwendungen sein.

## Patentansprüche

1. Vorrichtung zum Erzeugen eines Fingerabdrucksignals (24) aus einem Audiosignal (12), mit folgenden Merkmalen:
einer Einrichtung (14) zum Berechnen von Energiewerten für Frequenzbänder von zeitlich aufeinander folgenden Segmenten des Audiosignals, wobei ein Energiewert für ein Frequenzband von einer Energie des Audiosignals in dem Frequenzband abhängt, um aus dem Audiosignal eine Folge von Vektoren (16) von Energiewerten zu erhalten, wobei eine Vektorkomponente ein Energiewert in einem Frequenzband ist;
einer Einrichtung (18) zum Skalieren der Energiewerte, um eine Folge von skalierten Vektoren (20) zu erhalten; und
einer Einrichtung (22) zum zeitlichen Filtern der Folge von skalierten Vektoren (20), um eine gefilterte Folge (24) zu erhalten, die das Fingerabdrucksignal darstellt oder aus der das Fingerabdrucksignal herleitbar ist,
wobei die Einrichtung zum zeitlichen Filtern ein Tiefpassfilter (74) umfasst.

2. Vorrichtung gemäß Anspruch 1, bei der ein Segment des Audiosignals eine zeitliche Länge von mindestens 10 ms aufweist.

3. Vorrichtung gemäß Anspruch 1 oder 2, wobei die Einrichtung (14) zum Berechnen von Energiewerten für Frequenzbänder ausgebildet ist, um eine diskrete Fourier-Transformation (DFT) mittels einer schnellen Fourier-Transformation (FFT) auf dem Audiosignal (52) eines Segments durchzuführen, um Fourier-Koeffizienten (56) zu erhalten, Beträge der. Fourier-Koeffizienten zu quadrieren, um Betragsquadrate der Fourier-Koeffizienten zu erhalten, und die Betragsquadrate der Fourier-Koeffizienten bandweise aufzusummieren, um Energiewerte (16) für ein Frequenzband zu erhalten.

4. Vorrichtung gemäß einem der Ansprüche 1 bis 3, bei der die Frequenzbänder eine variable Bandbreite aufweisen, wobei eine Bandbreite bei Frequenzbändern mit höheren Frequenzen größer ist als eine Bandbreite bei Frequenzbändern mit niedrigeren Frequenzen.

5. Vorrichtung gemäß einem der Ansprüche 1 bis 4, bei der die Einrichtung (18) zum Skalieren ausgelegt ist, um einen Wertebereich der Energiewerte (36) zu komprimieren, so dass ein Wertebereich von komprimierten Energiewerten kleiner ist als ein Wertebereich von nichtkomprimierten Energiewerten.

6. Vorrichtung gemäß einem der Ansprüche 1 bis 5, bei der die Einrichtung (18) zum Skalieren ausgelegt ist, um die Energiewerte (36) zu normieren.

7. Vorrichtung gemäß einem der Ansprüche 1 bis 6, bei der die Einrichtung (18) zum Skalieren ausgelegt ist, um die Energiewerte (36) auf einen Wertebereich zwischen einer unteren Grenze und einer oberen Grenze zu skalieren oder zu logarithmieren.

8. Vorrichtung gemäß einem der Ansprüche 1 bis 6, bei der die Einrichtung (18) zum Skalieren ausgelegt ist, um die Energiewerte (36) entsprechend dem menschlichen Lautstärkeempfinden zu skalieren.

9. Vorrichtung gemäß einem der Ansprüche 1 bis 8, bei der die Einrichtung zum Skalieren eine Einrichtung zur Logarithmierung (70) und eine der Einrichtung zur Logarithmierung (70) nachgeschaltete Einrichtung zur Unterdrückung eines Gleichanteils umfasst.

10. Vorrichtung gemäß Anspruch 9, bei der die Einrichtung zur Unterdrückung eines Gleichanteils ein Hochpaßfilter (80) umfasst.

11. Vorrichtung gemäß einem der Ansprüche 1 bis 8, bei der die Einrichtung (18) zum Skalieren ausgelegt ist, um eine Normierung der Energiewerte unter Verwendung einer Gesamtenergie, die durch Bildung einer Summe mehrerer Energiewerte entsteht, durchzuführen, wobei die Normierung durch die bandweise Division der Energiewerte durch einen Normierungsfaktor, der gleich der Gesamtenergie ist, erfolgt.

12. Vorrichtung gemäß einem der Ansprüche 1 bis 11, bei der die Einrichtung (22) zum zeitlichen Filtern der Folge (20) von skalierten Vektoren ausgelegt ist, um eine zeitliche Glättung der Folge von skalierten Vektoren zu erzielen.

13. Vorrichtung gemäß Anspruch 12, bei der die Einrichtung (22) zum zeitlichen Filtern ein Tiefpaßfilter (74) mit einer Grenzfrequenz von weniger als 50 Hz umfasst.

14. Vorrichtung gemäß einem der Ansprüche 1 bis 13, bei der die Einrichtung (22) zum zeitlichen Filtern der Folge (20) von skalierten Vektoren ein Hochpaßfilter (80) mit einer Grenzfrequenz von weniger als 10 Hz umfasst.

15. Vorrichtung gemäß einem der Ansprüche 1 bis 14, bei der die Einrichtung (22) zum zeitlichen Filtern der Folge (20) von skalierten Vektoren eine Einrichtung zur Bildung der Differenz zwischen zwei zeitlich aufeinander folgenden Energiewerten in demselben Frequenzband umfasst.

16. Vorrichtung gemäß einem der Ansprüche 1 bis 15, bei dem die Einrichtung zum zeitlichen Filtern ein Tiefpassfilter (74) sowie eine mit einem Ausgang des Tiefpassfilters (74) verbundene Dezimationseinrichtung (76) aufweist, die ausgelegt ist, um die Zahl der aus dem Audiosignal hergeleiteten Vektoren zu verringern.

17. Vorrichtung gemäß einem der Ansprüche 1 bis 16, die ferner eine Einrichtung (84) zur Quantisierung umfasst, die der Einrichtung zum zeitlichen Filtern nachgeschaltet ist und die ausgelegt ist, um die gefilterte Folge zu quantisieren, um aus der gefilterten Folge das Fingerabdrucksignal herzuleiten.

18. Vorrichtung gemäß Anspruch 17, bei der die Einrichtung (22) zum zeitlichen Filtern ein Hochpaßfilter (80) aufweist, das ausgelegt ist, um den Wertebereich der zu quantisierenden Werte (82) zu verringern.

19. Vorrichtung gemäß Anspruch 17 oder 18, bei der die Einrichtung (84) zur Quantisierung so ausgelegt ist, dass eine Breite einer Quantisierungsstufe für einen großen Energiewerte größer als eine Breite einer Quantisierungsstufe für einen kleinen Energiewert ist.

20. Vorrichtung gemäß Anspruch 17 oder 18, bei der die Einrichtung (84) zur Quantisierung eine solche Einteilung der Quantisierungsstufen aufweist, dass ein maximaler relativer Quantisierungsfehler für einen großen und einen kleinen Energiewert innerhalb eines Toleranzbereichs gleich ist.

21. Vorrichtung gemäß Anspruch 20, wobei der Toleranzbereich ± 3 dB beträgt.

22. Vorrichtung gemäß Anspruch 17 oder 18, bei der die Einrichtung (84) zur Quantisierung ausgelegt ist, um Quantisierungsstufen aufgrund einer Amplitudenstatistik zu verwenden, wobei die Quantisierungsstufen gemäß der Amplitudenstatistik des zu quantisierenden Signals, die eine Aussage über eine relative Häufigkeit von Werten des zu quantisierenden Signals umfasst, eingestellt sind, wobei für einen Wertebereich mit Werten des zu quantisierenden Signals mit einer großen relativen Häufigkeit eine feine Einteilung der Quantisierungsstufen erfolgt und für einen Wertebereich mit Werten des zu quantisierenden Signals mit einer kleinen relativen Häufigkeit eine grobe Einteilung der Quantisierungsstufen erfolgt.

23. Vorrichtung gemäß Anspruch 17 oder 18, bei der die Einrichtung (84) zur Quantisierung so ausgelegt ist, daß sie einem Vektor der gefilterten Folge ein Symbol zuordnet.

24. Vorrichtung gemäß einem der Ansprüche 17 bis 23, bei der die Einrichtung (84) zur Quantisierung so ausgelegt ist, dass sie eine lineare Transformation auf einen Vektor der gefilterten Folge anwendet.

25. Verfahren zum Erzeugen eines Fingerabdrucksignals aus einem Audiosignal mit den folgenden Schritten:
Berechnen von Energiewerten für Frequenzbänder von zeitlich aufeinander folgenden Segmenten des Audiosignals, wobei ein Energiewert für ein Frequenzband von einer Energie des Audiosignals in dem Frequenzband abhängt, um aus dem Audiosignal eine Folge von Vektoren von Energiewerten zu erhalten, wobei eine Vektorkomponente einen Energiewert in einem Frequenzband ist;
Skalieren der Energiewerte, um eine Folge von skalierten Vektoren zu erhalten; und
zeitliches Filtern der Folge von skalierten Vektoren, um eine gefilterte Folge zu erhalten, die das Fingerabdrucksignal darstellt oder aus dem das Fingerabdrucksignal herleitbar ist,
wobei das zeitliche Filtern ein Tiefpass-Filtern (74) umfasst.

26. Vorrichtung zum Charakterisieren eines Audiosignals mit folgenden Merkmalen:
einer Vorrichtung zum Erzeugen eines Fingerabdrucksignals gemäß einem der Ansprüche 1 bis 24; und
einer Einrichtung zum Treffen einer Aussage über den Audioinhalt des Audiosignals aufgrund des Fingerabdrucksignals.

27. Verfahren zum Charakterisieren eines Audiosignals mit den folgenden Schritten:
Erzeugen eines Fingerabdrucksignals mit einem Verfahren gemäß Anspruch 25; und
Treffen einer Aussage über den Audioinhalt des Audiosignals aufgrund des Fingerabdrucksignals.

28. Verfahren zur Einrichtung einer Audio-Datenbank mit folgenden Schritten:
Erzeugen eines Fingerabdrucks für jedes in der Audio-Datenbank zu erfassende Audiosignal unter Verwendung des Verfahrens gemäß Anspruch 25;
für jedes zu erfassende Audiosignal, Einspeichern des Fingerabdrucks sowie von weiteren zu dem Audiosignal gehörende Informationen in der Audio-Datenbank, so dass eine Zuordnung von Fingerabdruck und korrespondierenden Informationen gegeben ist.

29. Verfahren zum Gewinnen von Informationen aufgrund einer Audiosignal-Datenbank, in der für mehrere Audiosignale zugehörige Fingerabdrucksignale, die mit einem Verfahren gemäß Anspruch 25 gebildet worden sind, gespeichert sind, und einem vorgegebenen Such-Audiosignal mit folgenden Schritten:
Bilden eines Such-Fingerabdrucksignals zu dem Such-Audiosignal mit einem Verfahren gemäß Anspruch 25;
Vergleichen des Such-Fingerabdrucksignals mit mindestens einem in der Datenbank gespeicherten Fingerabdrucksignal und Treffen einer Aussage über die Ähnlichkeit derselben.

30. Verfahren gemäß Anspruch 29, das ferner folgenden Schritt umfasst:
Ausgeben von Metadaten zu den Audiosignalen, auf denen die in der Datenbank gespeicherten Fingerabdrucksignale basieren, abhängig von der Aussage über die Ähnlichkeit des Such-Fingerabdrucksignals zu den in der Datenbank gespeicherten, Fingerabdrucksignalen.

31. Computer-Programm-Produkt mit einem Programmcode zur Durchführung des Verfahrens nach Anspruch 25, 27, 28, 29 oder 30, wenn das Computer-Programm auf einem Computer abläuft.

## Claims

1. Apparatus for producing a fingerprint signal (24) from an audio signal (12), comprising:
a means (14) for calculating energy values for frequency bands of segments of the audio signal which are successive in time, an energy value for a frequency band depending on an energy of the audio signal in the frequency band, so as to obtain a sequence of vectors (16) of energy values from the audio signal, a vector component being an energy value in a frequency band;
a means (18) for scaling the energy values to obtain a sequence of scaled vectors (20); and
a means (22) for temporally filtering the sequence of scaled vectors (20) to obtain a filtered sequence (24) which represents the fingerprint signal, or from which the fingerprint signal may be derived,
wherein the means for temporally filtering includes a low-pass filter (74).

2. Apparatus as claimed in claim 1, wherein one segment of the audio signal has a length in time of at least 10 ms.

3. Apparatus as claimed in claims 1 or 2, wherein the means (14) for calculating energy values for frequency bands is configured to perform a discrete Fourier transform (DFT) by means of a fast Fourier transform (FFT) on the audio signal (52) of a segment, to obtain Fourier coefficients (56), to square amounts of the Fourier coefficients, to obtain squared amounts of the Fourier coefficients, and to sum up the squared amounts of the Fourier coefficients band by band to obtain energy values (16) for a frequency band.

4. Apparatus as claimed in any of claims 1 to 3, wherein the frequency bands have a variable bandwidth, wherein a bandwidth with frequency bands having higher frequencies is larger than a bandwidth with frequency bands having lower frequencies.

5. Apparatus as claimed in any of claims 1 to 4, wherein the means (18) for scaling is configured to compress a range of values of the energy values (36) such that a range of values of compressed energy values is smaller than a range of non-compressed energy values.

6. Apparatus as claimed in any of claims 1 to 5, wherein the means (18) for scaling is configured to normalize the energy values (36).

7. Apparatus as claimed in any of claims 1 to 6, wherein the means (18) for scaling is configured to scale the energy values (36) to a range of values between a lower limit and an upper limit, or to take a logarithm of the energy values.

8. Apparatus as claimed in any of claims 1 to 6, wherein the means (18) for scaling is configured to scale the energy values (36) so as to correspond to the human loudness perception.

9. Apparatus as claimed in any of claims 1 to 8, wherein the means for scaling includes a means (70) for taking the logarithm and a means for suppressing a steady component which is connected downstream of the means (70) for taking the logarithm.

10. Apparatus as claimed in claim 9, wherein the means for suppressing a steady component includes a high-pass filter (80).

11. Apparatus as claimed in any of claims 1 to 8, wherein the means (18) for scaling is configured to perform a normalization of the energy values using a total energy created by forming a sum of several energy values, the normalization being performed by dividing the energy values, in a band-by-band manner, by a normalization factor which is identical with the total energy.

12. Apparatus as claimed in any of claims 1 to 11, wherein the means (22) for temporal filtering of the sequence (20) of scaled vectors is configured to achieve temporal smoothing of the sequence of scaled vectors.

13. Apparatus as claimed in claim 12, wherein the means (22) for temporal filtering includes a low-pass filter (74) having a cutoff frequency of less than 50 Hz.

14. Apparatus as claimed in any of claims 1 to 13, wherein the means (22) for temporal filtering of the sequence (20) of scaled vectors includes a high-pass filter (80) with a cutoff frequency of less than 10 Hz.

15. Apparatus as claimed in any of claims 1 to 14, wherein the means (22) for temporal filtering of the sequence (20) of scaled vectors includes a means for forming the difference between two energy values in the same frequency band which are successive in time.

16. Apparatus as claimed in any of claims 1 to 15, wherein the means for temporal filtering includes a low-pass filter (74) as well as a decimation means (76) connected to an output of the low-pass filter (74) and configured to reduce the number of vectors derived from the audio signal.

17. Apparatus as claimed in any of claims 1 to 16, which further includes a means (84) for quantizing which is connected downstream of the means for temporal filtering and is configured to quantize the filtered sequence so as to derive the fingerprint signal from the filtered sequence.

18. Apparatus as claimed in claim 17, wherein the means (22) for temporal filtering comprises a high-pass filter (80) configured to reduce the range of values of the values (82) to be quantized.

19. Apparatus as claimed in claims 17 or 18, wherein the means (84) for quantizing is configured such that a width of a quantization level for a high energy value is larger than a width of a quantization level for a small energy value.

20. Apparatus as claimed in claims 17 or 18, wherein the means (84) for quantizing comprises such a classification of the quantization levels that a maximum relative quantization error is identical for large and small energy values within a tolerance range.

21. Apparatus as claimed in claim 20, wherein the tolerance range is ± 3 db.

22. Apparatus as claimed in claims 17 or 18, wherein the means (84) for quantizing is configured to use quantization levels on the grounds of an amplitude statistic, the quantization levels being adapted in accordance with the amplitude statistic of the signal to be quantized, which statistic includes a statement about a relative frequency of values of the signal to be quantized, a fine classification of the quantizing steps being effected for a range of values with values of the signal to be quantized having a high relative abundance, and a coarse classification of the quantization levels being effected for a range of values with values of the signal to be quantized having a low relative abundance.

23. Apparatus as claimed in claims 17 or 18, wherein the means (84) for quantizing is configured such that it associates a symbol with a vector of the filtered sequence.

24. Apparatus as claimed in any of claims 17 to 23, wherein the means (84) for quantizing is configured such that it applies a linear transform to a vector of the filtered sequence.

25. Method for producing a fingerprint signal from an audio signal, comprising:
calculating energy values for frequency bands of segments of the audio signal which are successive in time, an energy value for a frequency band depending on an energy of the audio signal in the frequency band, so as to obtain a sequence of vectors (16) of energy values from the audio signal, a vector component being an energy value in a frequency band;
scaling the energy values to obtain a sequence of scaled vectors; and
temporally filtering the sequence of scaled vectors to obtain a filtered sequence (24) which represents the fingerprint signal, or from which the fingerprint signal may be derived,
wherein temporally filtering includes low-pass filtering (74).

26. Apparatus for characterizing an audio signal, comprising:
an apparatus for producing a fingerprint signal as claimed in any of claims 1 to 24; and
a means for making a statement about the audio content of the audio signal on the grounds of the fingerprint signal.

27. Method for characterizing an audio signal, comprising:
producing a fingerprint signal using a method as claimed in claim 25; and
making a statement about the audio content of the audio signal on the grounds of the fingerprint signal.

28. Method for establishing an audio database, comprising:
producing a fingerprint for each audio signal to be captured in the audio database, using the method as claimed in claim 25;
for each audio signal to be captured, storing in the fingerprint as well as further information in the audio database which belongs to the audio signal, so that an association of a fingerprint and the corresponding information is given.

29. Method for obtaining information on the grounds of an audio-signal database, wherein associated fingerprint signals having been formed by a method as claimed in claim 25 are stored for several audio signals, and for obtaining a predefined search audio signals, the method comprising:
forming a search fingerprint signal belonging to the search audio signal using a method as claimed in claim 25;
comparing the search fingerprint signal with at least one fingerprint signal stored in the database, and making a statement about the similarity thereof.

30. Method as claimed in claimed 29, further comprising:
outputting metadata to the audio signals on which the fingerprint signals stored in the database are based, depending on the statement about the similarity of the search fingerprint signal with the fingerprint signals stored in the database.

31. Computer program product having a program code for performing the method as claimed in claims 25, 27, 28, 29 or 30, when the computer program runs on a computer.

## Revendications

1. Dispositif pour générer un signal d'empreinte digitale (24) à partir d'un signal audio (12), aux caractéristiques suivantes:
un moyen (14) destiné à calculer des valeurs d'énergie pour des bandes de fréquences de segments successifs dans le temps du signal audio, une valeur d'énergie pour une bande de fréquences dépendant d'une énergie du signal audio dans la bande de fréquences, pour obtenir du signal audio une succession de vecteurs (16) de valeurs d'énergie, une composante de vecteur étant une valeur d'énergie dans une bande de fréquences;
un moyen (18) destiné à moduler les valeurs d'énergie, pour obtenir une succession de vecteurs modulés (20); et
un moyen (22) destiné à filtrer dans le temps la succession de vecteurs modulés (20), pour obtenir une succession filtrée (24) représentant le signal d'empreinte digitale ou de laquelle peut être dérivé le signal d'empreinte digitale,
le moyen destiné à filtrer dans le temps comportant un filtre passe-bas (74).

2. Dispositif selon la revendication 1, dans lequel un segment du signal audio présente une longueur temporelle d'au moins 10 ms.

3. Dispositif selon la revendication 1 ou 2, le moyen (14) destiné à calculer des valeurs d'énergie pour des bandes de fréquences étant réalisé de manière à effectuer, au moyen d'une transformation de Fourier rapide (FFT), une transformation de Fourier discrète (DFT) sur le signal audio (52) d'un segment, pour obtenir des coefficients de Fourier (56), élever au carré les quantités des coefficients de Fourier, pour obtenir des carrés des quantités des coefficients de Fourier, et pour additionner par bande les carrés des quantités des coefficients de Fourier, pour obtenir des valeurs d'énergie (16) pour une bande de fréquences.

4. Dispositif selon l'une des revendications 1 à 3, dans lequel les bandes de fréquences présentent une largeur de bande variable, une largeur de bande étant, pour les bandes à hautes fréquences, supérieure à une largeur de bande pour les bandes à basses fréquences.

5. Dispositif selon l'une des revendications 1 à 4, dans lequel le moyen (18) destiné à moduler est réalisé de manière à comprimer une plage des valeurs d'énergie (36) de sorte qu'une plage de valeurs d'énergie comprimée soit inférieure à une plage de valeurs d'énergie non comprimée.

6. Dispositif selon l'une des revendications 1 à 5, dans lequel le moyen (18) destiné à moduler est réalisé de manière à normaliser les valeurs d'énergie (36).

7. Dispositif selon l'une des revendications 1 à 6, dans lequel le moyen (18) destiné à moduler est réalisé de manière à moduler ou logarithmiser les valeurs d'énergie (36) à une plage de valeurs entre une limite inférieure et une limite supérieure.

8. Dispositif selon l'une des revendications 1 à 6, dans lequel le moyen (18) destiné à moduler est réalisé de manière à moduler les valeurs d'énergie (36) selon la perception de volume sonore humaine.

9. Dispositif selon l'une des revendications 1 à 8, dans lequel le moyen destiné à moduler comprend un moyen de logarithmisation (70) et un moyen de suppression d'une composante continue connectée après le moyen de logarithmisation (70).

10. Dispositif selon la revendication 9, dans lequel le moyen de suppression d'une composante continue comporte un filtre passe-haut (80).

11. Dispositif selon l'une des revendications 1 à 8, dans lequel le moyen (18) destiné à moduler est réalisé de manière à effectuer une normalisation des valeurs d'énergie à l'aide d'une énergie totale résultant de la formation d'une somme de plusieurs valeurs d'énergie, la normalisation ayant lieu par division par bande des valeurs d'énergie par un facteur de normalisation qui est égal à l'énergie totale.

12. Dispositif selon l'une des revendications 1 à 11, dans lequel le moyen (22) destiné à filtrer dans le temps la succession (20) de vecteurs modulés est conçu de manière à obtenir un lissage dans le temps de la succession de vecteurs modulés.

13. Dispositif selon la revendication 12, dans lequel le moyen (22) destiné à filtrer dans le temps comprend un filtre passe-bas (74) à fréquence limite inférieure à 50 Hz.

14. Dispositif selon l'une des revendications 1 à 13, dans lequel le moyen (22) destiné à filtrer dans le temps la succession (20) de vecteurs modulés comprend un filtre passe-haut (80) à fréquence limite inférieure à 10 Hz.

15. Dispositif selon l'une des revendications 1 à 14, dans lequel le moyen (22) destiné à filtrer dans le temps la succession (20) de vecteurs modulés comprend un moyen destiné à former la différence entre deux valeurs d'énergie successives dans le temps dans la même bande de fréquences.

16. Dispositif selon l'une des revendications 1 à 15, dans lequel le moyen (22) destiné à filtrer dans le temps présente un filtre passe-bas (74) ainsi qu'un moyen de décimation (76) relié à une sortie du filtre passe-bas (74) qui est conçu de manière à réduire le nombre de vecteurs dérivés du signal audio.

17. Dispositif selon l'une des revendications 1 à 16, comprenant par ailleurs un moyen (84) de quantification connecté après le moyen de filtration temporelle et réalisé de manière à quantifier la succession filtrée, pour dériver de la succession filtrée le signal d'empreinte digitale.

18. Dispositif selon la revendication 17, dans lequel le moyen (22) de filtration temporelle présente un filtre passe-haut (80) qui est réalisé de manière à réduire la plage des valeurs à quantifier (82).

19. Dispositif selon la revendication 17 ou 18, dans lequel le moyen (84) de quantification est conçu de sorte qu'une largeur d'une étape de quantification pour une haute valeur d'énergie soit supérieure à une largeur d'une étape de quantification pour une faible valeur d'énergie.

20. Dispositif selon la revendication 17 ou 18, dans lequel le moyen (84) de quantification présente une division des étapes de quantification telle qu'une erreur de quantification relative maximale pour une haute et une faible valeur d'énergie soit égale dans les limites d'une plage de tolérances.

21. Dispositif selon la revendication 20, la plage de tolérances étant de ± 3 dB.

22. Dispositif selon la revendication 17 ou 18, dans lequel le moyen (84) de quantification est conçu de manière à utiliser les étapes de quantification sur base d'une statistique d'amplitudes, les étapes de quantification étant réglées selon la statistique d'amplitudes du signal à quantifier comprenant une assertion sur une fréquence relative de valeurs du signal à quantifier, pour une plage de valeurs du signal à quantifier à grande fréquence relative ayant lieu un réglage fin des étapes de quantification et pour une plage de valeurs du signal à quantifier à faible fréquence relative ayant lieu un réglage approximatif des étapes de quantification.

23. Dispositif selon la revendication 17 ou 18, dans lequel le moyen (84) de quantification est conçu de sorte qu'il associe un symbole à un vecteur de la succession filtrée.

24. Dispositif selon l'une des revendications 17 à 23, dans lequel le moyen (84) de quantification est conçu de sorte qu'il applique une transformation linéaire à un vecteur de la succession filtrée.

25. Procédé pour générer un signal d'empreinte digitale à partir d'un signal audio, aux étapes suivantes consistant à:
calculer des valeurs d'énergie pour des bandes de fréquences de segments successifs dans le temps du signal audio, une valeur d'énergie pour une bande de fréquences dépendant d'une énergie du signal audio dans la bande de fréquences, pour obtenir du signal audio une succession de vecteurs de valeurs d'énergie, une composante de vecteur étant une valeur d'énergie dans une bande de fréquences;
moduler les valeurs d'énergie, pour obtenir une succession de vecteurs modulés; et
filtrer dans le temps la succession de vecteurs modulés, pour obtenir une succession filtrée représentant le signal d'empreinte digitale ou de laquelle peut être dérivé le signal d'empreinte digitale,
la filtration temporelle comprenant une filtration passe-bas (74).

26. Dispositif pour caractériser un signal audio, aux caractéristiques suivantes:
un dispositif destiné à générer un signal d'empreinte digitale selon l'une des revendications 1 à 24; et
un moyen destiné à effectuer une assertion sur le contenu audio du signal audio sur base du signal d'empreinte digitale.

27. Procédé pour caractériser un signal audio, aux étapes suivantes consistant à:
générer un signal d'empreinte digitale par un procédé selon la revendication 25; et
effectuer une assertion sur le contenu audio du signal audio sur base du signal d'empreinte digitale.

28. Procédé pour installer une banque de données audio, aux étapes suivantes consistant à:
générer une empreinte digitale pour chaque signal audio à détecter dans la banque de données audio, à l'aide du procédé selon la revendication 25;
pour chaque signal audio à détecter, mémoriser dans la banque de données audio l'empreinte digitale ainsi que d'autres informations appartenant au signal audio, de sorte que soit obtenue une association entre empreinte digitale et informations correspondantes.

29. Procédé pour obtenir des informations sur base d'une banque de données audio dans laquelle sont mémorisés, pour plusieurs signaux audio, des signaux d'empreinte digitale associés formés par un procédé selon la revendication 25 et d'un signal audio de recherche prédéterminé, aux étapes suivantes consistant à:
former un signal d'empreinte digitale de recherche pour le signal audio de recherche par un procédé selon la revendication 25;
comparer le signal d'empreinte digitale de recherche avec au moins un signal d'empreinte digitale mémorisé dans la banque de données et effectuer une assertion sur la similitude de ceux-ci.

30. Procédé selon la revendication 29, comprenant par ailleurs l'étape suivante consistant à:
sortir des métadonnées pour les signaux audio sur lesquelles se basent les signaux d'empreinte digitale mémorisés dans la banque de données, en fonction de l'assertion sur la similitude entre le signal d'empreinte digitale de recherche et les signaux d'empreinte digitale mémorisés dans la banque de données.

31. Programme d'ordinateur avec un code de programme pour réaliser le procédé selon la revendication 25, 27, 28, 29 ou 30 lorsque le programme d'ordinateur est exécuté sur un ordinateur.
